# EUROPEAN PATENT SPECIFICATION

(11) **EP 2 913 924 B1**
(45) Date of publication and mention of the grant of the patent: **30.08.2017**
(21) Application number: 15155630.5
(22) Date of filing: 18.02.2015
(51) Int. Cl.: H03K 3/0233, H03K 3/03

(54) **Ring oscillator, sensor, control method of ring oscillator, measuring method, program, and storage device**
Ringoszillator, Sensor, Steuerverfahren des Ringoszillators, Messverfahren, Programm und Speichervorrichtung
Oscillateur en anneau, capteur, procédé de commande d'oscillateur en anneau, procédé de mesure, programme et dispositif de stockage

(30) Priority: 28.02.2014 JP 2014039156
(43) Date of publication of application: 02.09.2015
(73) Proprietor: Hitachi, Ltd., Tokyo 100-8280 (JP)
(72) Inventor: Sato, Yasuo, Fukuoka, 820-8502 (JP); Simamura, Koutarou, Tokyo, 100-8280 (JP); Miura, Yukiya, Tokyo, 191-0065 (JP)
(74) Representative: Beetz & Partner mbB

(56) References cited:
- US-A1- 2005 225 415
- US-A1- 2005 248 415
- XIN XIN ET AL: "A Configurable Ring-Oscillator-Based PUF for Xilinx FPGAs", DIGITAL SYSTEM DESIGN (DSD), 2011 14TH EUROMICRO CONFERENCE ON, IEEE, 31 August 2011 (2011-08-31), pages 651-657, XP032058689, DOI: 10.1109/DSD.2011.88 ISBN: 978-1-4577-1048-3

## Description

### FIELD OF THE INVENTION

The present invention relates to a ring oscillator, a sensor, a control method of the ring oscillator, a measuring method, a program and a storage device, and particularly to a ring oscillator in an FPGA, etc.

### BACKGROUND OF THE INVENTION

Since an FPGA (field-programmable gate array) having a high degree of freedom, which is capable of changing a circuit configuration after its production, is high in flexibility after manufacture and can be developed at low cost for a short period of time, many systems each using a related art type LSI has been shifting to the FPGA.

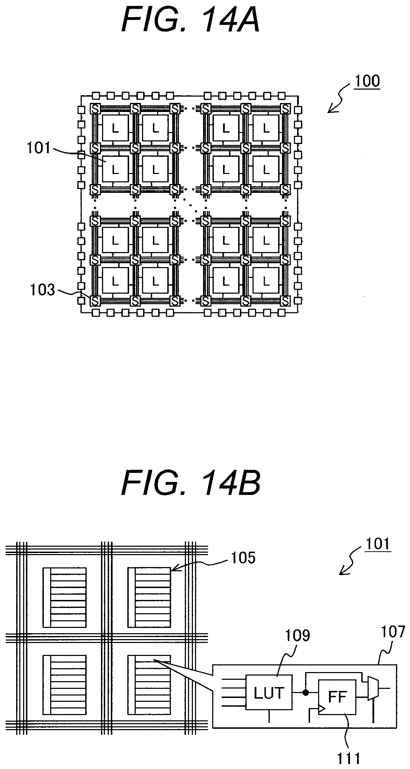

A configuration example of an FPGA is shown in FIGS. 14A and 14B. As shown in FIG. 14A, the FPGA has a plurality of logic blocks 101. Connections among the logic blocks 101 can be changed by switch matrices 103. Further, as shown in FIG. 14B, the logic block 101 has a plurality of LABs (Logic Array Blocks) 105. The LAB 105 is composed of a plurality of LEs (Logic Elements) 107. The LE 107 has an LUT (Look-Up Table) circuit 109 and an FF (Flip-Flop) 111.

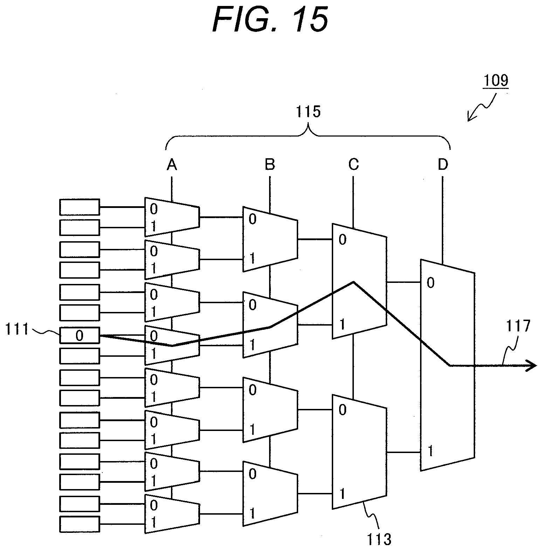

Further, a configuration example of the LUT circuit 109 is shown in FIG. 15. The LUT circuit 109 has a plurality of SRAMs 111, a plurality of selectors 113, input terminals 115, and an output terminal 117. By setting a logic value 0 or 1 to each SRAM 111, arbitrary combinational logic which can be represented by the number of the input terminals can be realized with the LUT circuit 109.

FIG. 15 illustrates where in the LUT circuit 109 whose input is 4 bits and output is a 1 bit, (A, B, C, D)=(0, 1, 1, 0) is inputted and 0 is outputted.

In order to enhance the reliability of the FPGA, the utilization of a ring oscillator capable of being utilized as a sensor mountable to a free location on the FPGA has bee expected.

The inventors have developed a method for suppressing degradation of a ring oscillator (refer to, for example, Patent Document 1 and Non-Patent Document 1). Further, the inventors have developed and proposed a ring oscillator using LUT circuits in an FPGA (refer to, for example, Non-Patent Document 2).

[Patent Document 1] Japanese Unexamined Patent Publication No. 2012-151662

[Non-Patent Document 1] Miura, et al, "On-chip Temperature and Voltage Measurement for Field Testing," 17th IEEE European Test Symposium, p.181, 2012-05.

[Non-Patent Document 2] Miyake, and three more authors, "A study on Design Structure of Ring Oscillators with Plural Frequency Characteristics in FPGAs", IEICE Technical Report, The Institute of Electronics, Information and Communication Engineers,

However, the techniques described in Patent Document 1 and Non-Patent Document 1 use a CMOS type inverting buffer as a delay element of a ring oscillator and are not applicable to degradation suppression where an LUT circuit is used as the delay element of the ring oscillator.

Further, in Non-Patent Document 2, a method for configuring the LUT circuit has been proposed where the LUT circuit is used as the delay element of the ring oscillator in the FPGA. There have however been considered configuration methods such as a layout and a connecting method for suppressing variations in the output frequency of the ring oscillator. Degradation suppression has not been specifically considered.

Thus, in the FPGA, there has still been room for a specific realization method for suppressing degradation of the ring oscillator using the LUT circuits and achieving its life prolongation.

Therefore, the present invention aims to provide a ring oscillator and the like capable of achieving life prolongation of the ring oscillator in an FPGA.

The document Xin Xin et al.: "A Configurable Ring-Oscillator-based PUF for Xilinx FPGAs" Digital System Design (DSD), 2011 14th Euromicro Conference on, 20110831 IEEE - ISBN 978-1-4577-1048-3 ; ISBN 1-4577-1048-X discloses a ring oscillator according to the preamble of claim 1. Further examples of FPGAs are disclosed in US 2005/248415 A1 and US 2005/225415 A1.

### SUMMARY OF THE INVENTION

The present invention is defined by the content of the independent claims. A first aspect of the present invention is a ring oscillator in an FPGA. The ring oscillator is equipped with a plurality of LUT circuits as delay elements connected annularly. Each LUT circuit includes a memory part having a plurality of individual memory cells respectively storing logic values therein, an output terminal connected to the next-stage LUT circuit, a first input terminal connected to an output terminal of the pre-stage LUT circuit, and a plurality of first gate circuits. Each first gate circuit has a p type transistor and/or an n type transistor and is brought into an on state or an off state according to the logic value inputted to the first input terminal. Each first gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The LUT circuits include first, second and third LUT circuits connected in order from the input side to the output side. The second LUT circuit and the third LUT circuit respectively have the same plurality of first gate circuits. The first gate circuits have p type transistors and n type transistors respectively. When not oscillating, the same part of the first gate circuits are respectively brought into an off state in the second LUT circuit and the third LUT circuit due to the logic value inputted to the first input terminal of the second LUT circuit and the logic value outputted from the output terminal thereof being the same.

A second aspect of the present invention provides the ring oscillator of the first aspect. In the ring oscillator, each of the LUT circuits further includes a second input terminal different from the first input terminal, and a plurality of second gate circuits. Each of the second gate circuits includes a p type transistor and/or an n type transistor and is brought into an on state or an off state according to the logic value inputted to the second input terminal. Each of the second gate circuits enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The second gate circuits include p type transistors and n type transistors respectively. When not oscillating, the memory part and the output terminal are connected to each other via a different part of the second gate circuits from the part of the second gate circuits capable of connecting the memory part and the output terminal when oscillating by inputting the logic value different from the logic value inputted to the second input terminal of the second LUT circuit when oscillating to the second input terminal.

A third aspect of the present invention provides the ring oscillator according to the second aspect, in which each of the second gate circuits is located on the output terminal side than the first gate circuits, and enters a state of allowing the logic value allowed to pass by one of the first gate circuits or the inverted logic value of the logic value allowed to pass by one of the first gate circuits to pass to the output terminal side in the on state.

A fourth aspect of the present invention provides the ring oscillator according to the second aspect, in which the first gate circuits and the second gate circuits are not separate circuits but combined gate circuits with a plurality of input, and the gate circuits are respectively brought into an on state or an off state according to the logic value inputted to the first input terminal and the logic value inputted to the second input terminal.

A fifth aspect of the present invention provides the ring oscillator according to any of the first to fourth aspects, in which in each of the LUT circuits at least other than the first-stage LUT circuit, the individual memory cell connected to the output terminal when not oscillating stores therein the logic value inputted to the first input terminal when not oscillating.

A sixth aspect of the present invention provides a ring oscillator in an FPGA.
The ring oscillator is equipped with a plurality of LUT circuits as delay elements connected annularly. Each of the LUT circuits includes a memory part having a plurality of individual memory cells respectively storing logic values therein, an output terminal connected to the next-stage LUT circuit, a first input terminal connected to an output terminal of the pre-stage LUT circuit, a plurality of first gate circuits, a second input terminal different from the first input terminal, and a plurality of second gate circuits. Each first gate circuit has a p type transistor and/or an n type transistor and is brought into an on state or an off state according to the logic value inputted to the first input terminal. Each first gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The first gate circuits have p type transistors and n type transistors respectively. Each of the second gate circuits has a p type transistor and/or an n type transistor and is brought into an on state or an off state according to the logic value inputted to the second input terminal. Each second gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The second gate circuits have p type transistors and n type transistors respectively. When not oscillating, the memory part and the output terminal are connected to each other via a different part of the second gate circuits from the part of the second gate circuits capable of connecting the memory part and the output terminal when oscillating by inputting the logic value different from the logic value inputted to the second input terminal when oscillating to the second input terminal in at least the two LUT circuits of the LUT circuits.

A seventh aspect of the present invention provides the ring oscillator according to the sixth aspect, in which the first gate circuits and the second gate circuits are not separate circuits but combined gate circuits with a plurality of input, and the gate circuits are respectively brought into an on state or an off state according to the logic value inputted to the first input terminal and the logic value inputted to the second input terminal.

An eighth aspect of the present invention provides a ring oscillator in an FPGA. The ring oscillator is equipped with only a first LUT circuit and a second LUT circuit connected in order from the input side to the output side as delay elements connected annularly. Each of the first LUT circuit and the second LUT circuit includes a memory part having a plurality of individual memory cells respectively storing logic values therein, an output terminal connected to the next-stage LUT circuit, a first input terminal connected to an output terminal of the pre-stage LUT circuit, and a plurality of first gate circuits. Each of the first gate circuits has a p type transistor and/or an n type transistor and is brought into an on state or an off state according to the logic value inputted to the first input terminal. Each first gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The first LUT circuit and the second LUT circuit respectively have the same plurality of first gate circuits. The first gate circuits have p type transistors and n type transistors respectively. When not oscillating, the same part of the first gate circuits are respectively brought into an off state in the first LUT circuit and the second LUT circuit due to the logic value inputted to the first input terminal of the first LUT circuit and the logic value outputted from the output terminal thereof being the same.

A ninth aspect of the present invention provides a ring oscillator in an FPGA. The ring oscillator is equipped with only one LUT circuit as a delay element. The LUT circuit includes a memory part having a plurality of individual memory cells respectively storing logic values therein, an output terminal, a first input terminal connected to the output terminal, a plurality of first gate circuits, a second input terminal different from the first input terminal, and a plurality of second gate circuits. Each of the first gate circuits has a p type transistor and/or an n type transistor and is brought into an on state or an off state according to the logic value inputted to the first input terminal. Each of the first gate circuits enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The first gate circuits have p type transistors and n type transistors respectively. Each of the second gate circuits has a p type transistor and/or an n type transistor and is brought into an on state or an off state according to the logic value inputted to the second input terminal. Each of the second gate circuits enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The second gate circuits have p type transistors and n type transistors respectively. When not oscillating, the memory part and the output terminal are connected to each other via a different part of the second gate circuits from the part of the second gate circuits capable of connecting the memory part and the output terminal when oscillating by inputting the logic value different from the logic value inputted to the second input terminal when oscillating to the second input terminal.

A tenth aspect of the present invention provides a sensor which measures a frequency, a temperature, a voltage or the degree of variation in production and is equipped with the ring oscillator described in any of the first to ninth aspects.

An eleventh aspect of the present invention provides a control method of a ring oscillator in an FPGA. The ring oscillator is equipped with a plurality of LUT circuits as delay elements connected annularly. Each LUT circuit includes a memory part having a plurality of individual memory cells respectively storing logic values therein, an output terminal connected to the next-stage LUT circuit, a first input terminal connected to an output terminal of the pre-stage LUT circuit, and a plurality of first gate circuits. Each first gate circuit has a p type transistor and/or an n type transistor and is brought into an on state or an off state according to the logic value inputted to the first input terminal. Each first gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The LUT circuits include first, second and third LUT circuits connected in order from the input side to the output side. The second LUT circuit and the third LUT circuit respectively have the same plurality of first gate circuits. The first gate circuits have p type transistors and n type transistors respectively. The control method of the ring oscillator includes a step of when not oscillating, the same part of the first gate circuits are respectively brought into an off state in the second LUT circuit and the third LUT circuit by making the logic value inputted to the first input terminal of the second LUT circuit and the logic value outputted from the output terminal thereof being the same.

A twelfth aspect of the present invention provides the control method of the ring oscillator according to the eleventh aspect. In the ring oscillator, each of the LUT circuits further includes a second input terminal different from the first input terminal, and a plurality of second gate circuits. Each of the second gate circuits includes a p type transistor and/or an n type transistor and is brought into an on state or an off state according to the logic value inputted to the second input terminal. Each of the second gate circuits enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The second gate circuits include p type transistors and n type transistors respectively. When not oscillating, the memory part and the output terminal are connected to each other via a different part of the second gate circuits from the part of the second gate circuits capable of connecting the memory part and the output terminal when oscillating by inputting the logic value different from the logic value inputted to the second input terminal of the second LUT circuit when oscillating to the second input terminal.

A thirteenth aspect of the present invention provides the control method of the ring oscillator according to the eleventh or twelfth aspect, in which in each of the LUT circuits at least other than the first-stage LUT circuit, the individual memory cell connected to the output terminal when not oscillating stores therein the logic value inputted to the first input terminal when not oscillating.

A fourteenth aspect of the present invention provides a control method of a ring oscillator in an FPGA. The ring oscillator is equipped with a plurality of LUT circuits as delay elements connected annularly. Each of the LUT circuits includes a memory part having a plurality of individual memory cells respectively storing logic values therein, an output terminal connected to the next-stage LUT circuit, a first input terminal connected to an output terminal of the pre-stage LUT circuit, a plurality of first gate circuits, a second input terminal different from the first input terminal, and a plurality of second gate circuits. Each first gate circuit has a p type transistor and/or an n type transistor and is brought into an on state or an off state according to the logic value inputted to the first input terminal. Each first gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The first gate circuits have p type transistors and n type transistors respectively. Each of the second gate circuits has a p type transistor and/or an n type transistor and being brought into an on state or an off state according to the logic value inputted to the second input terminal. Each second gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The second gate circuits have p type transistors and n type transistors respectively. The control method of the ring oscillator includes a step of when not oscillating, the memory part and the output terminal are connected to each other via a different part of the second gate circuits from the part of the second gate circuits capable of connecting the memory part and the output terminal when oscillating by inputting the logic value different from the logic value inputted to the second input terminal when oscillating to the second input terminal in at least the two LUT circuits of the LUT circuits.

A fifteenth aspect of the present invention provides a method of measuring a physical quantity of a ring oscillator in an FPGA. The ring oscillator is equipped with a plurality of LUT circuits as delay elements connected annularly. Each LUT circuit includes a memory part having a plurality of individual memory cells respectively storing logic values therein, an output terminal connected to the next-stage LUT circuit, a first input terminal connected to an output terminal of the pre-stage LUT circuit, and a plurality of first gate circuits. Each first gate circuit has a p type transistor and/or an n type transistor and is brought into an on state or an off state according to the logic value inputted to the first input terminal. Each first gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The LUT circuits include first, second and third LUT circuits connected in order from the input side to the output side. The second LUT circuit and the third LUT circuit respectively have the same plurality of first gate circuits. The method of measuring a physical quantity includes a step of when not oscillating, bringing the same part of the first gate circuits into an off state in the second LUT circuit and the third LUT circuit by making the logic value inputted to the first input terminal of the second LUT circuit and the logic value outputted from the output terminal thereof being the same, and a step of measuring a frequency outputted from the ring oscillator when oscillating.

A sixteenth aspect of the present invention provides a method of measuring a physical quantity of a ring oscillator in an FPGA. The ring oscillator is equipped with a plurality of LUT circuits as delay elements connected annularly. Each of the LUT circuits includes a memory part having a plurality of individual memory cells respectively storing logic values therein, an output terminal connected to the next-stage LUT circuit, a first input terminal connected to an output terminal of the pre-stage LUT circuit, a plurality of first gate circuits, a second input terminal different from the first input terminal, and a plurality of second gate circuits. Each first gate circuit has a p type transistor and/or an n type transistor and is brought into an on state or an off state according to the logic value inputted to the first input terminal. Each first gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The first gate circuits have p type transistors and n type transistors respectively. Each of the second gate circuits has a p type transistor and/or an n type transistor and being brought into an on state or an off state according to the logic value inputted to the second input terminal. Each second gate circuit enters a state of allowing the logic value in one of the individual memory cells or the inverted logic value of the logic value in one of the individual memory cells to pass to the output terminal side in the on state, and enters a state of not allowing the passage of the logic values stored in the individual memory cells to the output terminal side in the off state. The second gate circuits have p type transistors and n type transistors respectively. The measuring method includes a step of when not oscillating, the memory part and the output terminal are connected to each other via a different part of the second gate circuits from the part of the second gate circuits capable of connecting the memory part and the output terminal when oscillating by inputting the logic value different from the logic value inputted to the second input terminal when oscillating to the second input terminal in at least the two LUT circuits of the LUT circuits, and a step of measuring a frequency outputted from the ring oscillator when oscillating.

A seventeenth aspect of the present invention provides the measuring method according to the fifteenth or sixteenth aspect. In the ring oscillator, each of the LUT circuits further includes a second input terminal different from the first input terminal, and a plurality of second gate circuits. Each of the second gate circuits includes a p type transistor and/or an n type transistor and is brought into an on state or an off state according to the logic value inputted to the second input terminal. Each of the second gate circuits is located on the output terminal side than the first gate circuits and enters a state of allowing the logic value allowed to pass by one of the first gate circuits or the inverted logic value of the logic value allowed to pass by one of the first gate circuits to pass to the output terminal side in the on state, and enters a state of not allowing the passage of the logic values stored in the individual memory cells to the output terminal side in the off state. The second gate circuits include p type transistors and n type transistors respectively. The measuring method includes a step of when not oscillating, inputting a logic value at which a specific second gate circuit connecting a specific individual memory cell to the output terminal is brought into an on state to the second input terminal and also when oscillating, inputting the logic value at which the specific second gate circuit is brought into an on state to the second input terminal, thereby to measure a first frequency outputted by the ring oscillator; a step of when not oscillating, inputting a logic value at which the specific second gate circuit is brought into an off state to the second input terminal and when oscillating, inputting a logic value at which the specific second gate circuit is brought into an on state to the second input terminal, thereby to measure a second frequency outputted by the ring oscillator; and a step of comparing the first frequency and the second frequency.

An eighteenth aspect of the present invention provides the measuring method according to the fifteenth or sixteenth aspect. In the ring oscillator, each of the LUT circuits further includes a second input terminal different from the first input terminal, and a plurality of second gate circuits. Each of the second gate circuits includes a p type transistor and/or an n type transistor and is brought into an on state or an off state according to the logic value inputted to the second input terminal. Each of the second gate circuits is located on the output terminal side than the first gate circuits and enters a state of allowing the logic value allowed to pass by one of the first gate circuits or the inverted logic value of the logic value allowed to pass by one of the first gate circuits to pass to the output terminal side in the on state, and enters a state of not allowing the passage of the logic values stored in the individual memory cells to the output terminal side in the off state. The second gate circuits include p type transistors and n type transistors respectively. The measuring method includes a step of when not oscillating, inputting a logic value at which a specific second gate circuit connecting a specific individual memory cell to the output terminal is brought into an off state to the second input terminal and when oscillating, inputting the logic value at which the specific second gate circuit is brought into an on state to the second input terminal, thereby to measure a second frequency outputted by the ring oscillator; a step of when not oscillating, inputting a logic value at which the specific second gate circuit is brought into an off state to the second input terminal and also when oscillating, inputting a logic value at which the specific second gate circuit is brought into an on state to the second input terminal, thereby to measure a first frequency outputted by the ring oscillator; and a step of comparing the first frequency and the second frequency.

A nineteenth aspect of the present invention provides a program for allowing a computer to execute the control method of the ring oscillator according to any of the eleventh to fourteenth aspects of the present invention, or the measuring method according to any of the fifteenth to eighteenth aspects of the present invention.

A twentieth aspect of the present invention provides a computer-readable storage device having stored therein the program according to the nineteenth aspect of the present invention.

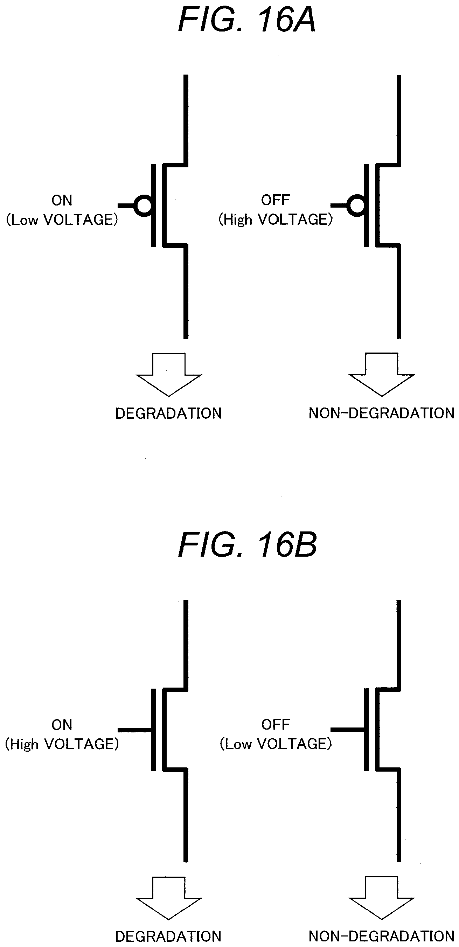

A degradation phenomenon of a transistor will first be described. As transistors of each LUT circuit which forms a ring oscillator, a PMOS transistor is normally used as a p type transistor, and an NMOS transistor is used as an n type transistor. As illustrated in FIGS. 16A and 16B, NBTI (Negative Bias Temperature Instability) has generally been known as a degradation phenomenon of the PMOS transistor. Further, PBTI (Positive Bias Temperature Instability) has been known as a degradation phenomenon of the NMOS transistor. PMOS's NBTI becomes a problem in many processes, whereas NMOS's PBTI becomes a problem in ultra-fine processes. Thus, the p type transistor and the n type transistor normally differ from each other in degradation phenomenon.

Both NBTI and PBTI cause the progress of degradation in a state in which a gate voltage is turned on (on state). In the case of the PMOS transistor, it becomes an on state at a Low voltage. In the case of the NMOS transistor, it becomes an on state at a High voltage. Therefore, by specifying a suitable gate voltage to the transistor, the degradation of a transistor desired to suppress its degradation can be suppressed and a phenomenon of degradation of a ring oscillator can be suppressed.

In a normal ring oscillator, logic values outputted from delay elements like LUT circuits change every other one. Therefore, in the normal ring oscillator, for example, even when one pays attention to specific p type (or n type) transistors contributing to the oscillation and desires to bring the transistors into an off state, only the transistors in every other delay elements can be brought into an off state. As a result, only p type (n type) transistors in about half of the LUT circuits can be brought into off, and the remaining p type (n type) transistors are turned on, so that degradation of the entire p type (n type) transistors cannot be integrally suppressed.

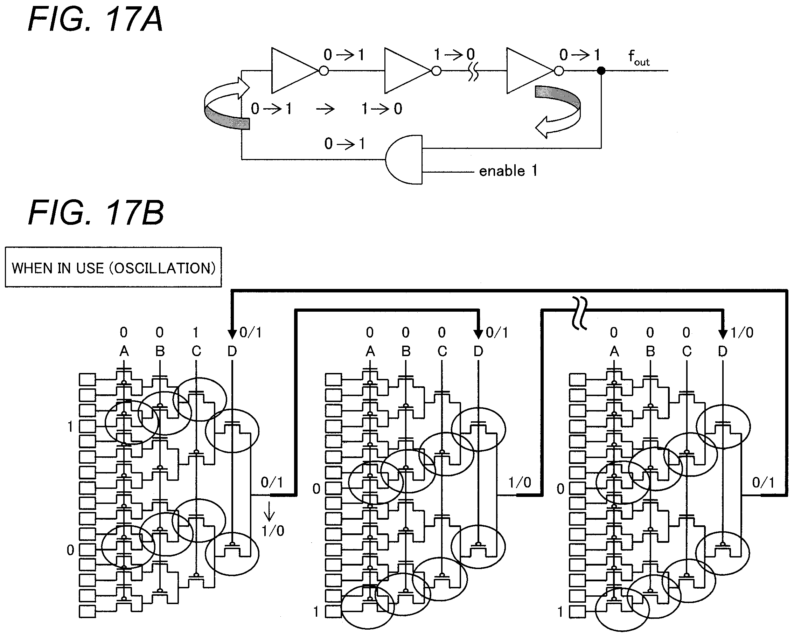

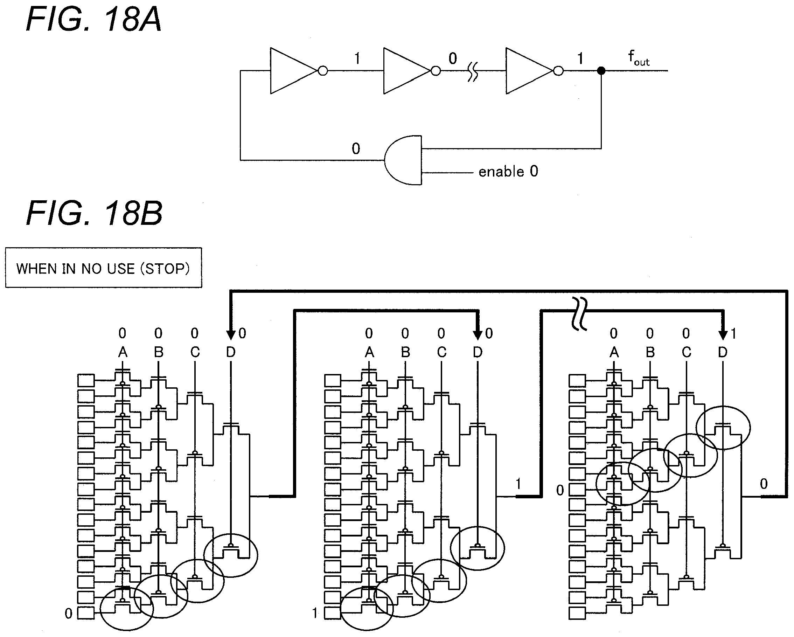

This phenomenon will be explained using FIGS. 17A and 17B and FIGS. 18A and 18B. FIGS. 17A and 17B are diagrams showing one example illustrative of a ring oscillator based on a conventional way of thinking when oscillating. FIGS. 18A and 18B are diagrams showing one example illustrative of the ring oscillator based on the conventional way of thinking when not oscillating. By comparing FIGS. 17A and 17B and FIGS. 18A and 18B, transistors surrounded by circles in LUT circuits on and after a second stage in FIG. 18B are respectively brought into an on state when both oscillating and not oscillating, so that degradation thereof progresses. About half of the transistors which contribute to the oscillation have the problem of such a progress in degradation.

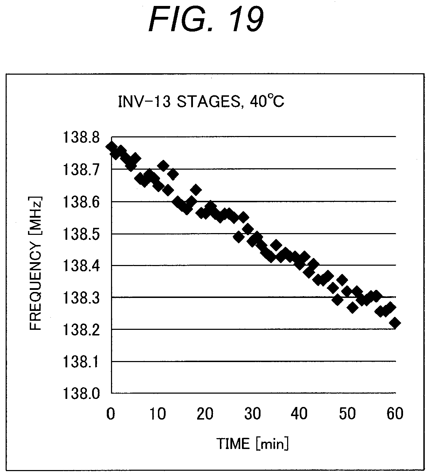

FIG. 19 shows experimental results of degradation measurements of the normal ring oscillator. Degradation was measured every minute at 40°C for an hour. Except for at the time of the measurement, the ring oscillator is stopped (power supply is ON). It is understood from FIG. 19 that an output frequency is reduced even just for an hour. This shows that the degradation of the ring oscillator is a serious problem.

The ring oscillator according to each aspect of the present application invention utilizes LUT circuits. Unlike inverted buffers or the like, the LUT circuits are capable of setting logic values outputted from output terminals. When oscillating, the logic value outputted from each LUT circuit needs, for example, changing every other one, etc. depending on the purpose of the ring oscillator. When not oscillating, it is not necessary to take into consideration a restriction by the purpose of the ring oscillator.

Further, the ring oscillator is normally placed in an oscillating state temporarily and in a non-oscillating state for most of the time. For example, the ring oscillator is oscillating only for an extreme short period of time (a few 10ms per minute) during which it performs monitor measurement as a sensor, and is placed in the non-oscillating state for other time period. Therefore, the non-oscillating state plays an important role in the degradation suppression of the transistor.

Therefore, according to each aspect of the present application invention, a distinction is made between when oscillating and when not oscillating, and attention is paid to the non-oscillating state of the ring oscillator. Thus, it is possible to input logic values which bring p type transistors (or n type transistors) of first gate circuits desired to suppress their degradation into an off state, to first input terminals of adjoining LUT circuits other than the first-stage LUT circuit in the ring oscillator. Consequently, it is possible to efficiently suppress degradation of the p type transistors (or n type transistors) desired to suppress their degradation in the LUT circuits more than half of the LUT circuits. In other words, of the p type transistors (or n type transistors) which contribute to the oscillation, the proportion of the transistors suppressed in degradation can be increased more than in the related art. It is therefore possible to achieve life prolongation as the entire ring oscillator.

In many cases, there is assumed a demand to suppress NBTI of a PMOS transistor (p type transistor) in which degradation is easy to progress. In that case, the degradation of more PMOS transistors can be suppressed by inputting a logic value which brings the PMOS transistor into an off state to the first input terminal when not oscillating, as compared with the case where an inverted logic value thereof is inputted to the first input terminal. There is also however a case where it is desired to suppress PBTI of the NMOS transistor (n type transistor), such as where it is manufactured in the ultra-fine process. In that case, a logic value which brings the NMOS transistor into an off state may be inputted to the first input terminal when not oscillating. According to the present invention, there is a feature in that if attention is paid to the difference in degradation phenomenon between the p type transistor and the n type transistor, and when not oscillating, a logic value which brings any transistor desired to suppress its degradation into an off state is applied to a first input terminal of a given LUT circuit, the same sort of transistors in the next-stage LUT circuit can also be brought into an off state, and the degradation of p type or n type transistors can be suppressed in a plurality of successive LUT circuits.

Also, according to the second aspect of the present invention, a non-oscillating state is realized using different part of second gate circuits from the part of second gate circuits which contribute to the oscillation. Thus, a logic value stored in the individual memory cell different from that when oscillating is connected to an output terminal, so that bringing the first gate circuit having contributed to the oscillation into an off state, and putting the ring oscillator in non-oscillating state are easy to be compatible. As a result, the life prolongation of the ring oscillator becomes further easy.

Further, according to the third aspect of the present invention, since the oscillation is done on the memory part side, the number of transistors passing from the time when a logic value is inputted from a pre-stage LUT circuit to an input terminal contributing to the oscillation to the time when a logic value of each individual memory cell is outputted is increased by at least the number of second gate circuits located on the output terminal side. It can be expected that the influence of degradation of each oscillation transistor on the entirety can be reduced by inputting the logic values used to suppress the degradation of these transistors to a second input terminal. As a result, the life prolongation of the ring oscillator becomes further easy.

Furthermore, according to the fourth aspect of the present invention, gate circuits brought into an on state or an off state according to logic values applied to a plurality of input terminals make it possible to achieve similar life prolongation of a ring oscillator.

Still further, according to the fifth aspect of the present invention, the oscillating and non-oscillating of a ring oscillator can be controlled using the same LUT circuits having stored the same logic value groups therein, as a plurality of delay elements of the ring oscillator. Therefore, the suppression of a phenomenon of degradation in the ring oscillator using the LUT circuits becomes further easy.

Also, according to the sixth aspect of the present invention, when it is possible to bring a p type transistor (or n type transistor) which contributes to the oscillation into an off state by a value inputted to a second input terminal, the life prolongation of a ring oscillator can be achieved by paying attention to the control on its input to a second input terminal when not oscillating.

In particular, according to the seventh aspect of the present invention, for example, when first gate circuits and second gate circuits are combined and controlled by a value inputted to a first input terminal and a value inputted to a second input terminal, the life prolongation of a ring oscillator can be effectively controlled.

Also, according to the eighth and ninth aspects of the present invention, even when LUT circuits as delay elements are low in number, it is possible to achieve the life prolongation of a ring oscillator.

Further, according to the tenth aspect of the present invention, it is possible to provide a sensor which has degradation resistance and measures a stable frequency, a temperature, a voltage or the degree of variation in production.

Furthermore, according to the fifteenth and sixteenth aspects of the present invention, the physical quantity of a ring oscillator capable of outputting a stable frequency for a long time can be measured from an output frequency of the ring oscillator. The physical quantity described herein includes, for example, the quantity of degradation for each degradation mode, the quantity of degradation corresponding to a selector's logic value, the degree of influence on the delay amount of the entire LUT due to the degradation mode (NBTI/PBTI or the like) and the in-LUT position of a degradation selector, and the amount of recovery when the ring oscillator is held in a non-degrading state.

Still further, according to the seventeenth and eighteenth aspects of the present invention, it is possible to measure the quantity of degradation of a ring oscillator based on a degradation mode of a specific transistor by comparing output frequencies on which on and off states of the transistor are reflected.

### BRIEF DESCRIPTION OF THE DRAWINGS

FIGS. 1A and 1B are respectively diagrams illustrating an outline of a ring oscillator 1 according to an embodiment of the invention of the present application;
FIGS. 2A and 2B respectively illustrate an operational example where PMOS degradation suppression is performed in an LUT circuit 3 shown in FIGS. 1A and 1B;
FIG. 3 is a flow diagram illustrating one example of processing for designing the ring oscillator 1 shown in FIGS. 1A and 1B;
FIGS. 4A and 4B are respectively diagrams illustrating an operational example where PMOS degradation suppression different from FIGS. 2A and 2B is performed in the LUT circuit 3 shown in FIGS. 1A and 1B;
FIGS. 5A and 5B are respectively diagrams illustrating an operational example where NMOS degradation suppression is performed in the LUT circuit 3 shown in FIGS. 1A and 1B;
FIG. 6 is a diagram illustrating other specific examples of individual memory cells 21 and a first selection part 23 shown in FIGS. 1A and 1B;
FIGS. 7A and 7B are respectively diagrams illustrating normal PMOS degradation used in experiments;
FIGS. 8A and 8B are respectively diagrams illustrating PMOS positive degradation used in experiments;
FIGS. 9A and 9B are respectively diagrams illustrating PMOS degradation suppression used in experiments;
FIGS. 10A through 10F are respectively diagrams illustrating results of the experiments in FIGS. 7A and 7B through 9A and 9B at two locations;
FIG. 11 is a diagram illustrating one example of a ring oscillator in the case of only a single LUT circuit;
FIG. 12 is a diagram illustrating one example of a ring oscillator in the case of only two LUT circuits;
FIG. 13 is a diagram illustrating one example of an LUT circuit where selection parts have a plurality of inputs;
FIGS. 14A and 14B are respectively diagrams illustrating a configuration example of a general FPGA;
FIG. 15 is a diagram illustrating a configuration example of a general LUT circuit;
FIGS. 16A and 16B are respectively diagrams illustrating NBTI corresponding to a PMOS degradation phenomenon and PBTI corresponding to an NMOS degradation phenomenon;
FIGS. 17A and 17B are respectively diagrams illustrating one example illustrative of a ring oscillator based on a conventional way of thinking when oscillating;
FIGS. 18A and 18B are respectively diagrams illustrating one example illustrative of the ring oscillator based on the conventional way of thinking when not oscillating; and
FIG. 19 is a diagram illustrating experimental results with degradation measurements of a normal ring oscillator.

### DETAILED DESCRIPTION OF THE PREFERRED EMBODIMENTS

Preferred embodiments of the invention of the present application will hereinafter be described with reference to the accompanying drawings. Incidentally, the modes of the present application invention are not limited to the following embodiments.

### <Embodiments>

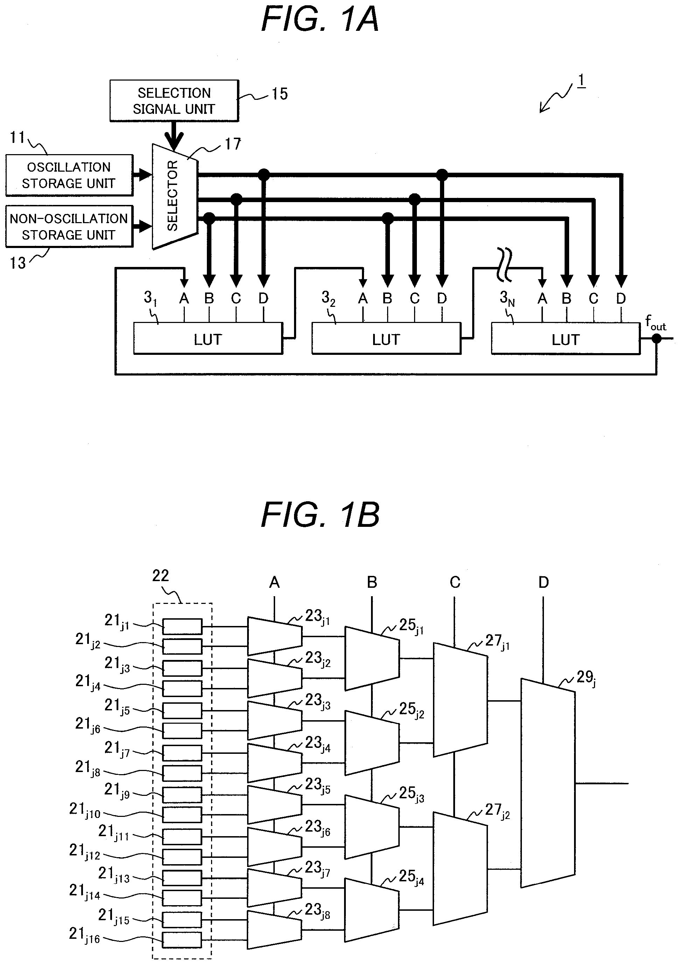

FIGS. 1A and 1B are respectively diagrams illustrating an outline of a ring oscillator 1 according to an embodiment of the present application invention. FIG. 1A is a block diagram illustrating the overview of the ring oscillator 1. FIG. 1B illustrates one example of a specific configuration of an LUT circuit 3.

The ring oscillator 1 shown in FIGS. 1A and 1B is used in an FPGA. The ring oscillator 1 is equipped with a plurality of LUT circuits 3₁, ..., 3_{N} (where N: odd number greater than or equal to 3, and subscripts may be omitted), an oscillation storage unit 11, a non-oscillation storage unit 13, a selection signal unit 15, and a selector 17.

The LUT circuits 3 are respectively delay elements in the ring oscillator 1. Each LUT circuit 3 is equipped with four input terminals A, B, C and D. The input terminal A is used for oscillation in the ring oscillator. The LUT circuit 3₁ outputs a logic value to the input terminal A (one example of "first input terminal" in the claim of the present application) of the LUT circuit 3₂. Likewise, the LUT circuit 3ᵢ (where i: integer greater than or equal to 1 and less than or equal to N-1) outputs a logic value to the input terminal A (one example of "first input terminal" in the claim of the present application) of the LUT circuit 3ᵢ₊₁. The LUT circuit 3_{N} outputs a logic value to the outside as fout and outputs the same to the input terminal A (one example of "first input terminal" in the claim of the present application) of the LUT circuit 3₁. Connecting the plural LUT circuits 3 annularly means a state in which as shown in FIG. 1A, the LUT circuit 3ᵢ outputs the logic value to the LUT circuit 3ᵢ₊₁ of the next stage, and the LUT circuit 3_{N} outputs the logic value to the LUT circuit 3₁.

Each of the LUT circuits 3 functions as the ring oscillator by outputting an inverted logic value (i.e., outputting 1 when 0 is inputted or outputting 0 when 1 is inputted) of an input logic value when oscillating.

One or plural input logic values are applied to each of the LUT circuits 3 in addition to the values inputted from other LUT circuits by being connected annularly. There is shown in FIG. 1B, a case where such input logic values are 3 bits. These 3-bit input logic values are applied to the input terminals B, C and D.

The oscillation storage unit 11 stores therein the input logic values inputted to each LUT circuit 3 when oscillating (i.e., when being used as the ring oscillator). The non-oscillation storage unit 13 stores therein the input logic value inputted to each LUT circuit 3 when not oscillating (i.e., when being not used as the ring oscillator).

The selection signal unit 15 applies signals different when oscillating and not oscillating to the selector 17.

The selector 17 selects either the oscillation storage unit 11 or the non-oscillation storage unit 13 according to the signal obtained from the selection signal unit 15 and applies an input logic value to each LUT circuit 3.

One example of the configuration of each LUT circuit 3 will be described with reference to FIG. 1B. Each LUT circuit 3ⱼ (where j: integer greater than or equal to 1 and less than or equal to N) is equipped with sixteen individual memory cells 21ⱼ₁, ..., 21ⱼ₁₆ (individual memory cell 21 being one example of "individual memory cell" in the claim of the present application), eight first selection parts 23ⱼₗ, ..., 23ⱼ₈, four second selection parts 25ⱼₗ, ..., 25ⱼ₄, two third selection parts 27ⱼₗ and 27ⱼ₂, and a fourth selection part 29ⱼ. The first selection parts 23 are located on the output terminal side than the individual memory cells 21. The second selection parts 25 are located on the output terminal side than the first selection parts 23. The third selection parts 27 are located on the output terminal side than the second selection parts 25. The fourth selection part 29 is located on the output terminal side than the third selection parts 27. A memory part 22 (one example of "memory part" in the claim of the present application) is a combination of the individual memory cells 21.

The individual memory cells 21 respectively store logic values therein.

The first selection parts 23 respectively enter a state of being capable of selecting any of the individual memory cells 21, based on the logic value applied to the input terminal A and outputting the logic value stored therein. It is assumed below that the first selection parts 23 respectively select the odd-numbered individual memory cells 21 when the logic value of the input terminal A is 1, and select the even-numbered individual memory cells 21 when the logic value is 0. For example, the first selection part 23ⱼ₁ selects the individual memory cell 21ⱼ₁ when the logic value of the input terminal A is 1, and selects the individual memory cell 21ⱼ₂ when the logic value is 0.

The second selection parts 25 respectively enter a state of being capable of selecting any of the first selection parts 23, based on the logic value applied to the input terminal B and outputting the logic value. It is assumed below that the second selection parts 25 respectively select the odd-numbered first selection parts 23 when the logic value of the input terminal B is 1, and select the even-numbered first selection parts 23 when the logic value is 0. For example, the second selection part 25ⱼ₁ selects the first selection part 23ⱼ₁ when the logic value of the input terminal B is 1, and selects the first selection part 23ⱼ₂ when the logic value is 0.

The third selection parts 27 respectively enter a state of being capable of selecting any of the second selection parts 25, based on the logic value applied to the input terminal C and outputting the logic value. It is assumed below that the third selection parts 27 respectively select the odd-numbered second selection parts 25 when the logic value of the input terminal C is 1, and select the even-numbered second selection parts 25 when the logic value is 0. For example, the third selection part 27ⱼ₁ selects the second selection part 25ⱼ₁ when the logic value of the input terminal C is 1, and selects the second selection part 25ⱼ₂ when the logic value is 0.

The fourth selection part 29 enters a state of being capable of selecting either one of the third selection parts 27, based on the logic value applied to the input terminal D and outputting the logic value. The fourth selection part 29ⱼ selects the third selection part 27ⱼ₁ when the logic value of the input terminal D is 1, and selects the third selection part 27ⱼ₂ when the logic value is 0.

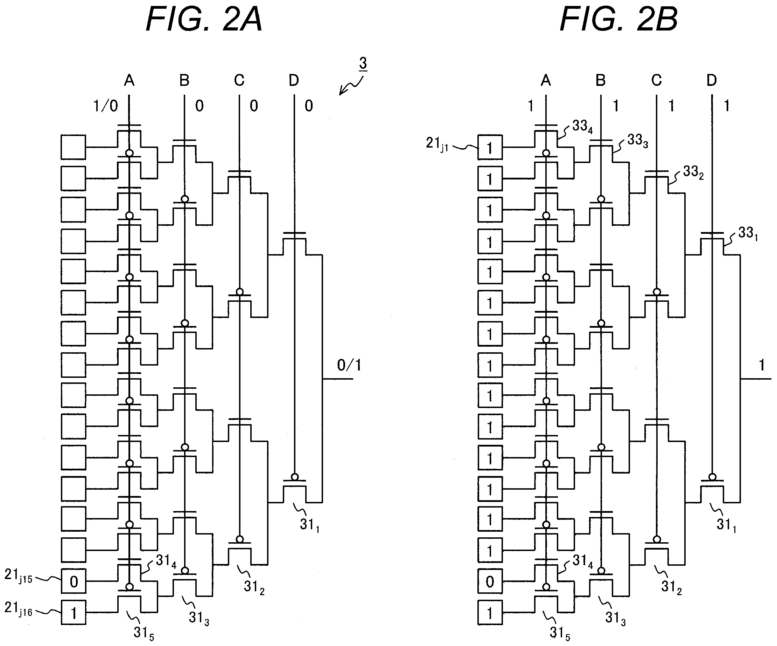

FIGS. 2A and 2B respectively show an operation example where PMOS degradation suppression is done in the LUT circuit 3 shown in FIGS. 1A and 1B. FIG. 2A shows the LUT circuit 3 when oscillating where the input terminal A is used for oscillation, and FIG. 2B shows the LUT circuit 3 when not oscillating (in no use and stop).

The first selection part 23, the second selection part 25, the third selection part 27 and the fourth selection part 29 are respectively comprised of an NMOS transistor (one example of "first gate circuit" and "n type transistor" in the claim of the present application) as one selected when the logic value of the input terminal is 1, and comprised of a PMOS transistor (one example of "first gate circuit" and "p type transistor" in the claim of the present application) as one selected when the logic value is 0. Each individual first selection part 23 includes one NMOS transistor (one example of "first gate circuit" and "n type transistor" in the claim of the present application), and one PMOS transistor (one example of "first gate circuit" and "p type transistor" in the claim of the present application). The first selection parts 23 include eight NMOS transistors and eight PMOS transistors as a whole. Each individual second selection part 25 includes one NMOS transistor (one example of "second gate circuit" and "n type transistor" in the claim of the present application) and one PMOS transistor (one example of "second gate circuit" and "p type transistor" in the claim of the present application). The second selection parts 25 include four NMOS transistors and four PMOS transistors as a whole. Each individual third selection part 27 includes one NMOS transistor (one example of "second gate circuit" and "n type transistor" in the claim of the present application) and one PMOS transistor (one example of "second gate circuit" and "p type transistor" in the claim of the present application). The third selection parts 27 include two NMOS transistors and two PMOS transistors as a whole. The fourth selection part 29 includes one NMOS transistor (one example of "second gate circuit" and "n type transistor" in the claim of the present application) and one PMOS transistor (one example of "second gate circuit" and "p type transistor" in the claim of the present application).

FIG. 2A shows the LUT circuit when oscillating. The input terminal A is used for oscillation, and 1 or 0 is inputted from the pre-stage LUT circuit 3 when oscillating. The input terminals B, C and D are respectively given 0, 0 and 0 when oscillating. Therefore, when oscillating, transistors 31₁, 31₂ and 31₃ in FIG. 2A are respectively brought into an on state, and either one of transistors 31₄ and 31₅ is brought into an on state according to the logic value of the input terminal A. Further, 0 and 1 have been stored in individual memory cells 21ⱼ₁₅ and 21ⱼ₁₆ respectively. When the logic value of the input terminal A is 1, 0 is outputted to the output terminal. When the logic value of the input terminal A is 0, 1 is outputted to the output terminal.

FIG. 2B shows the LUT circuit when not oscillating. The input terminal A is inputted with a logic value 1 to suppress PMOS degradation. Consequently, at least the transistor 31₅ is brought into an off state so that its degradation can be suppressed. Further, the input terminals B, C and D are respectively given 1, 1 and 1. Thus, transistors 33₁, 33₂, 33₃ and 33₄ respectively turn into an on state. On the other hand, the transistors 31₁, 31₂, 31₃ and 31₄ are respectively brought into an off state. As a result, PMOS used when oscillating are all capable of suppressing degradation when not oscillating. Incidentally, NMOS degradation in the second selection parts 25, the third selection parts 27 and the fourth selection part 29 do not affect the oscillation. Therefore, when a degradation phenomenon is only NBTI in PMOS, it is possible to completely suppress degradation when not oscillating, in the transistors 31₁, 31₂, 31₃, 31₄ and 31₅ which contribute to the oscillation. On the other hand, the transistor 31₄ corresponding to the NMOS transistor of the first selection part 23 is brought into an on state upon both of the oscillation and the non-oscillation. Therefore, when PBTI occurs, the transistor 31₄ has the potential for being degraded, but the influence of its degradation can be suppressed to the minimum. Then, the logic value 1 is outputted even to the output terminal by storing 1 being the same logic value as the logic value 1 inputted to the input terminal A to the individual memory cell 21ⱼ₁. Thus, the next-stage LUT circuit can also suppress PMOS degradation in like manner.

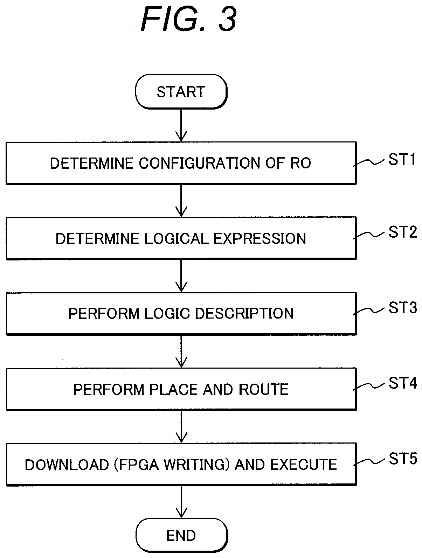

FIG. 3 is a flow diagram showing one example of processing for designing the ring oscillator 1 shown in FIGS. 1A and 1B, having the LUT circuits 3. The configuration of the ring oscillator is first determined (Step ST1), a logical expression is determined (Step ST2) and a logic description is performed (Step ST3). Then, place and route is performed (Step ST4). Here, the place and route can also be automatically carried out, but normally the result is adjusted by fixing and correcting wirings by hands after that. Then, data indicating this place and route result is downloaded to the FPGA and written therein, followed by its execution (Step ST5).

An example to determine the logic value applied to each individual memory cell will be specifically described with the case that one desires to suppress PMOS degradation as an example. In Step ST1, the configuration of the ring oscillator 1 such as the number of LUTs is determined on the basis of the oscillation condition and the restriction such as to accommodate it in a LAB.

In Step ST2, it is necessary to output 0 or 1 to the output terminal where 1 or 0 is inputted to the input terminal A when oscillating. Therefore, it is decided that 0 and 1 are respectively stored in the individual memory cells 21ⱼ₁₅ and 21ⱼ₁₆. Further, when not oscillating, the values stored by the individual memory cell 21ⱼ₁ is determined to be 1 because the transistor 31₅ has to be off state and the values of the input terminal A and outputted from the output terminal are same. The values of the individual memory cells other than the above are determined in such a manner that a logical expression indicating the relationship between the logic values inputted to the input terminals A to D and the logic values outputted therefrom is simplified. Now, assume that 0 is inputted to the input terminals B to D when oscillating, and 1 is inputted to the input terminals B to D when not oscillating. Then, the output logic value from the output terminal is expressed in F=!A+B+C+D. If based on this logical expression, the logic value 1 is applied to all of the individual memory cells 21ⱼ₂ to 21ⱼ₁₄.

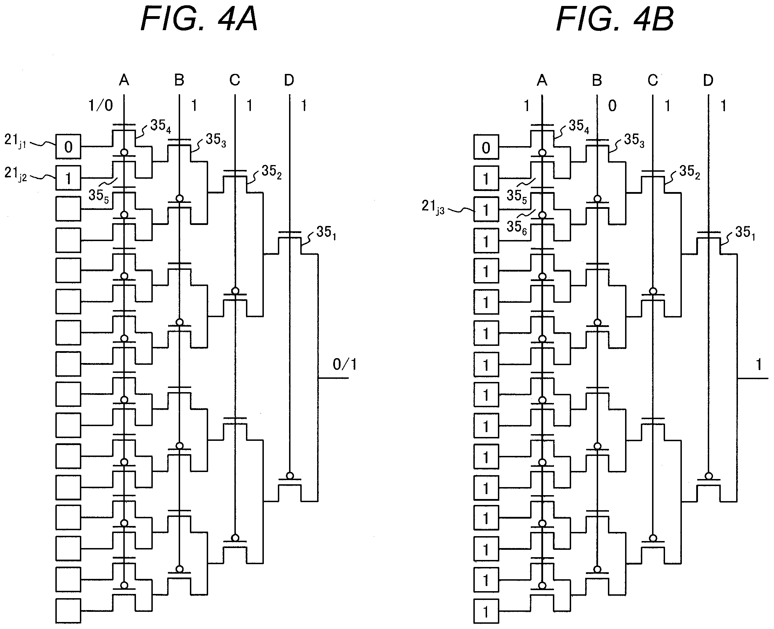

One example of other degradation suppression of PMOSs will subsequently be described with reference to FIGS. 4A and 4B. FIG. 4A shows an LUT circuit when oscillating, and FIG. 4B shows an LUT circuit when not oscillating. In this example, the input terminal A is used for oscillation, and 1, 1 and 1 are respectively applied to the input terminals B, C and D when oscillating. Therefore, transistors 35₁, 35₂ and 35₃ are respectively placed in an on state, and either one of transistors 35₄ and 35₅ becomes an on state. 0 and 1 have been stored in the individual memory cells 21ⱼ₁ and 21ⱼ₂ respectively. When the logic value of the input terminal A is 1, 0 is outputted to the output terminal. When the logic value of the input terminal A is 0, 1 is outputted to the output terminal. When not oscillating, 1 is applied to the input terminal A. Therefore, the transistor 35₅ is brought into an off state so that its degradation is suppressed. Further, 0, 1 and 1 are respectively applied to the input terminals B, C and D. For that reason, the transistor 35₃ is brought into an off state and the transistor 35₆ is brought into an on state. 1 has been stored in the individual memory cell 21ⱼ₃. Therefore, the same logic value 1 as the logic value 1 applied to the input terminal A is outputted to the output terminal. Incidentally, when PBTI also occurs, NMOS degradation of the first, third and fourth selection parts 23, 27 and 29 cannot be suppressed, but no PMOS degradation due to NBTI occurs.

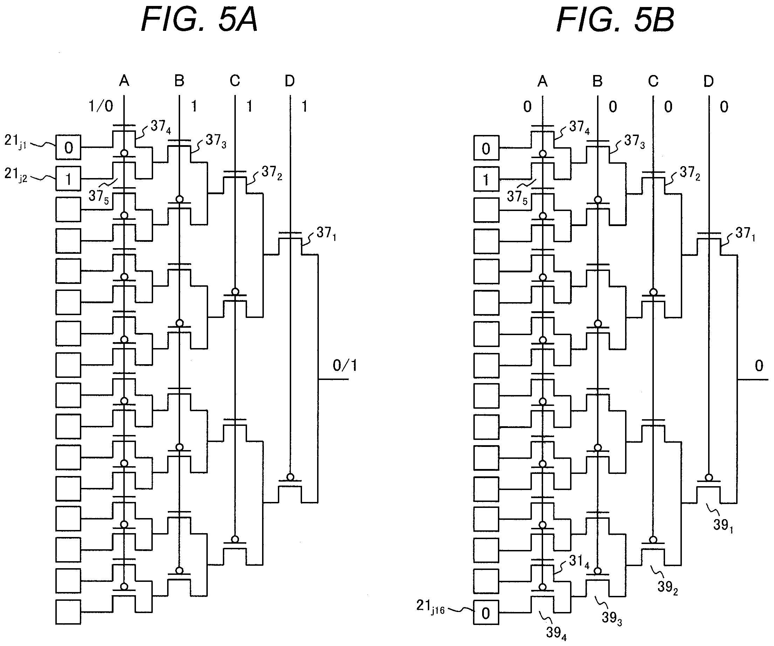

One example of the suppression of NMOS degradation will subsequently be described with reference to FIGS. 5A and 5B. FIG. 5A shows an LUT circuit when oscillating, and FIG. 5B shows an LUT circuit when not oscillating. In this example, the input terminal A is used for oscillation. When oscillating, the input terminals B, C and D are respectively given 1, 1 and 1. Therefore, transistors 37₁, 37₂ and 37₃ are respectively brought into an on state, and either one of transistors 37₄ or 37₅ is brought into an on state. 0 and 1 have been stored in the individual memory cells 21ⱼ₁ and 21ⱼ₂ respectively. When the logic value of the input terminal A is 1, 0 is outputted to the output terminal. When the logic value of the input terminal A is 0, 1 is outputted to the output terminal. When not oscillating, 0 is applied to the input terminal A. Therefore, the transistor 37₄ is brought into an off state so that its degradation is suppressed. Further, the input terminals B, C and D are respectively given 0, 0 and 0. For that reason, the transistors 37₁, 37₂ and 37₃ are respectively brought into an off state, and transistors 39₁, 39₂, 39₃ and 39₄ are respectively brought into an on state. 0 has been stored in the individual memory cell 21ⱼ₁₆. Therefore, the same logic value 0 as the logic value 0 applied to the input terminal A is outputted to the output terminal. It is thus possible to suppress all degradation of NMOSs used when oscillating. Incidentally, PMOS degradation of the transistor 37₅ occurs, but PMOS degradation of the second, third and fourth selection parts do not affect the oscillation.

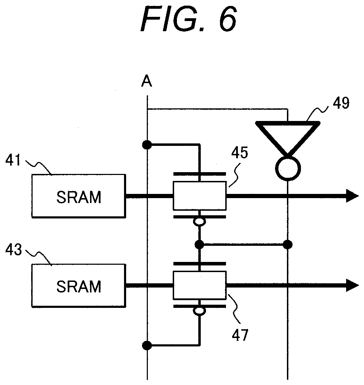

FIG. 6 is a diagram showing another example of the individual memory cells 21 and the first selection part 23. SRAMs 41 and 43 correspond to the individual memory cells 21 and respectively store logic values therein. A pass gate 45 (one example of "first gate circuit" or "second gate circuit" in the claim of the present application) includes a p type transistor (one example of "p type transistor" in the claim of the present application) and an n type transistor (one example of "n type transistor" in the claim of the present application). A pass gate 47 (one example of "first gate circuit" or "second gate circuit") is also similar. The pass gates 45 and 47 are respectively brought into an on state and an off state according to the logic values 1 and 0 of the input terminal A. The logic values inputted to the input terminal A are inputted to an NMOS input of the pass gate 45 and a PMOS input of the pass gate 47 as they are. Further, an inverting buffer 49 outputs the logic value 0 and 1 to a PMOS input of the pass gate 45 and an NMOS input of the pass gate 47, respectively according to the logic values 1 and 0 of the input terminal A.

For example, when the logic value inputted to the input terminal A is 0, NBTI degradation occurs in the p type transistor of the pass gate 47. Further, NBTI degradation occurs even in a p type transistor which configures the inverting buffer 49, and hence the speed of outputting 1 to the n type transistor of the pass gate 47 is degraded. As a result, the degradation of the function of the pass gate 47 of causing the logic value to pass therethrough occurs. On the other hand, when the logic value inputted to the input terminal A is 1, NBTI degradation occurs in the p type transistor of the pass gate 45, but no NBTI degradation occurs in the p type transistor which configures the inverting buffer 49. Therefore, even when such a configuration is taken, a specific degradation mode can be suppressed according to the logic value inputted to the input terminal A, and the life prolongation of the ring oscillator 1 described above can be achieved.

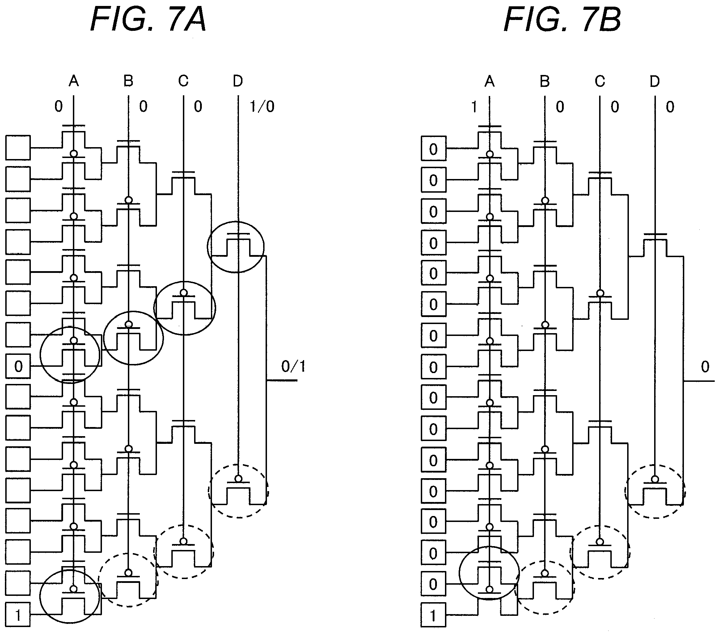

Subsequently, experiments performed on the effects by the present application invention will be described with reference to FIGS. 7A and 7B to FIGS. 10A through 10F. FIGS. 7A and 7B are respectively diagrams illustrating a configuration example of an LUT circuit corresponding to "normal PMOS degradation". The individual memory cells are set in such a manner that the output logic value = !A·!B·!C·!D (i.e., 1 is outputted where A, B, C and D are all 0 and otherwise, 0 is outputted). FIG. 7A shows the LUT circuit when oscillating, and FIG. 7B shows the LUT circuit when not oscillating. When oscillating in FIG. 7A, the input terminal D is used for the oscillation, and 1 or 0 is inputted from a pre-stage LUT circuit. Other input terminals A, B and C are respectively given the logic value 0. In this case, transistors that can become an on state are given round marks in solid and broken lines. When not oscillating in FIG. 7B, the input terminals A, B, C and D are respectively inputted with 1, 0, 0 and 0, and transistors held in an on state are respectively given round marks in solid and broken lines. In FIGS. 7A and 7B, the round marks by the broken lines indicate the transistors that can become the on state when oscillating, and the transistors that can become the on state when not oscillating. Therefore, these transistors become easy to be degraded.

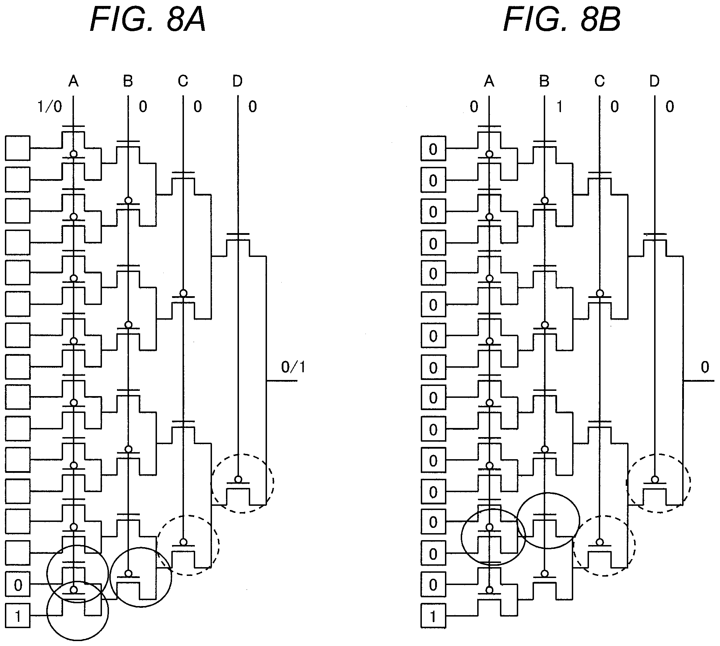

FIGS. 8A and 8B are respectively diagrams showing a configuration example of an LUT circuit corresponding to "PMOS positive degradation". The individual memory cells are similarly set in such a manner that the output logic value = !A·!B·!C·!D. FIG. 8A shows the LUT circuit when oscillating, and FIG. 8B shows the LUT circuit when not oscillating. When oscillating in FIG. 8A, the input terminal A is used for the oscillation, and 1 or 0 is inputted from a pre-stage LUT circuit. Other input terminals B, C and D are respectively given the logic value 0. In this case, transistors respectively held in an on state are given round marks in solid and broken lines. When not oscillating in FIG. 8B, the input terminals A, B, C and D are respectively inputted with 0, 1, 0 and 0, and transistors respectively held in an on state are respectively given round marks in solid and broken lines. In FIGS. 8A and 8B, the round marks by the broken lines indicate the transistors always held in the on state both when oscillating and not oscillating. Therefore, these transistors become easy to be degraded.

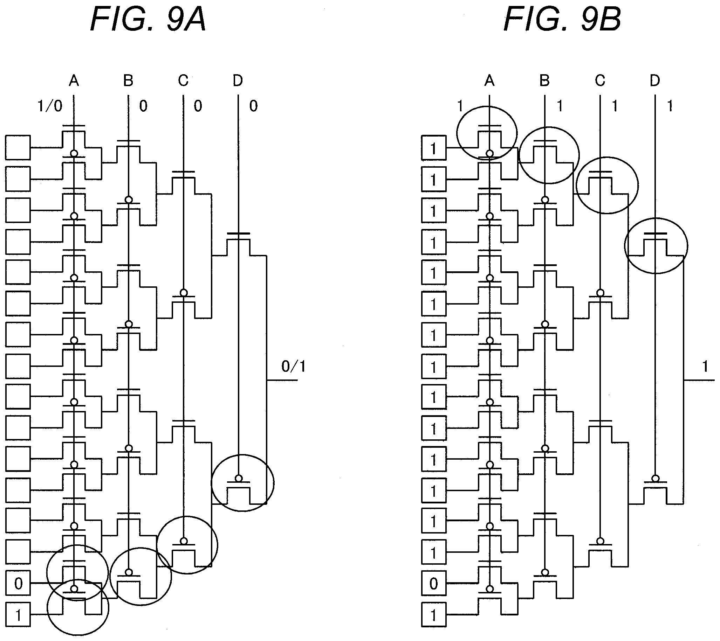

FIGS. 9A and 9B are respectively are diagrams illustrating a configuration example of an LUT circuit corresponding to "suppression of PMOS degradation". The individual memory cells are set in such a manner that the output logic value = A·!B·!C·!D (i.e., 1 is outputted where A is 1 and B, C and D are 0 and otherwise, 0 is outputted). FIG. 9A shows the LUT circuit when oscillating, and FIG. 9B shows the LUT circuit when not oscillating. When oscillating in FIG. 9A, the input terminal A is used for the oscillation, and 1 or 0 is inputted from a pre-stage LUT circuit. Other input terminals B, C and D are respectively given the logic value 0. In this case, transistors respectively held in an on state are given round marks in solid lines. When not oscillating in FIG. 9B, the input terminals A, B, C and D are respectively inputted with the logic value 1, and transistors respectively held in an on state are respectively given round marks in solid lines. In FIGS. 9A and 9B, there are no transistors each of which can become an on state both when oscillating and not oscillating. It is hence possible to suppress PMOS degradation when not oscillating of each transistor used when oscillating.

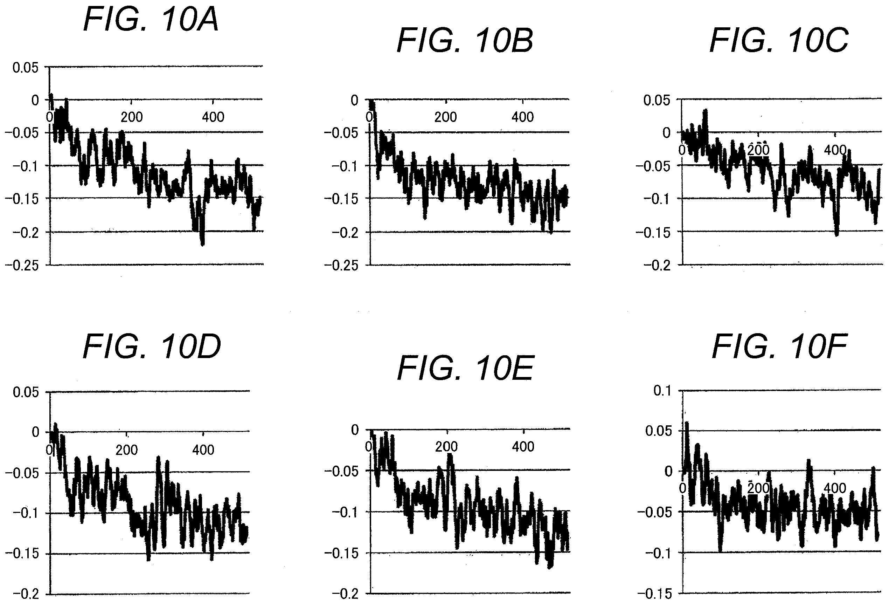

FIGS. 10A through 10F are respectively diagrams for evaluating degradation at two locations (hereinafter called "location 1" and "location 2"). At each location, heating is done for 520 minutes, and the moving average of nine measurements is taken. The respective figures are as follows: FIGS. 10A, FIG. 10B, and FIG. 10C at the location 1 respectively show normal PMOS degradation (refer to FIGS. 7A and 7B), PMOS positive degradation (refer to FIGS. 8A and 8B), and suppression of PMOS degradation (refer to FIGS. 9A and 9B). FIG. 10D, FIG. 10E, and FIG. 10F at the location 2 respectively show normal PMOS degradation, PMOS positive degradation, and suppression of PMOS degradation. The horizontal axis corresponds to the time (minute) during which FPGA is being heated (degradation acceleration), and the vertical axis indicates the ratio at which the frequency of the ring oscillator changes with time. The value of the vertical axis being minus indicates that the frequency becomes gradually slower. At the location 1, the peak at the normal PMOS degradation in FIG. 10A exceeds -0.2, and the peak is near -0.2 even at the PMOS positive degradation in FIG. 10B. According to the suppression of the PMOS degradation in FIG. 10C, the peak is near -0.15. It is therefore understood that the degradation has been suppressed. Further, even at the location 2, the peaks at the normal PMOS degradation in FIG. 10D and the PMOS positive degradation in FIG. 10E exceed -0.15. According to the suppression of the PMOS degradation in FIG. 10F, the peak is in the vicinity of -0.1. It is therefore understood that the degradation has been suppressed. Thus, the quantity of degradation of the ring oscillator can be measured by making comparisons with the cases where the degradation is accelerated and suppressed every specific degradation mode of the ring oscillator. Even in addition to the degradation quantity for each degradation mode, it is possible to measure physical quantities such as the quantity of degradation corresponding to the logic value of the selector, the degree of influence on the delay amount of the entire LUT due to the degradation mode (NBTI/PBTI or the like) or the in-LUT position of the degradation selector, or the amount of recovery where the ring oscillator is held in a non-degraded state, etc. Those listed herein are an example of "physical quantity" described in the claim of the present application.

Incidentally, although the present embodiment has described where the number of the LUT circuits N is an odd number greater than or equal to three, the present invention is applicable even to the case where N is 1 or an even number. In order to configure the ring oscillator, when oscillating, the odd number of LUT circuits selected out of the N LUT circuits may output the inverses of the input terminals connected to the pre-stage LUT circuits, and the remaining LUT circuits may output the same values as at the input terminals connected to the pre-stage LUT circuits.

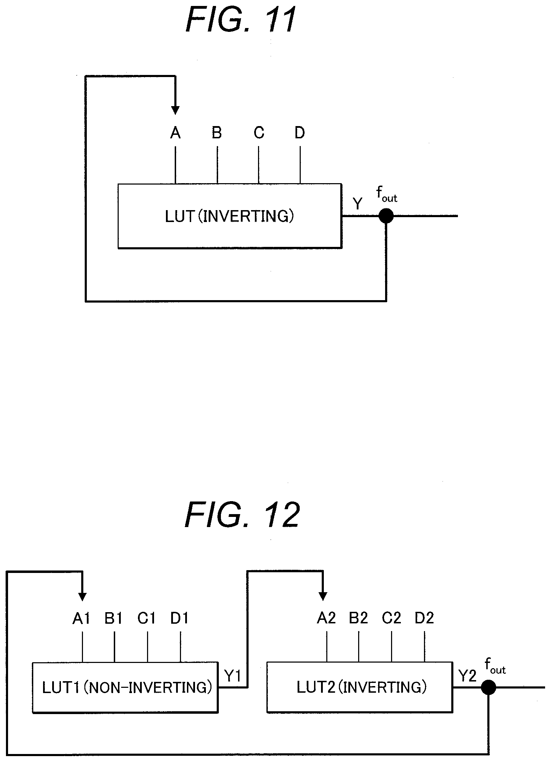

When N = 1 as shown in FIG. 11, for example, an LUT circuit is operated such that one output terminal and one input terminal are connected and an inverted logic value is inputted to the output terminal each time the loop goes around. At this time, when oscillating, the following relation is established: the input terminal A=0→output terminal Y=1 →input terminal A=1 →output terminal Y=0→input terminal A=0→.... Further, when N = 2 as shown in FIG. 12, the ring oscillator is configured by an LUT circuit which outputs the same value as the value inputted to its input terminal from the pre-stage, and an LUT circuit which outputs the inverse of a value inputted to its input terminal from the pre-stage. At this time, when oscillating, the following relation is established: LUT1 input terminal A1=0→LUT1 output terminal Y1=0→LUT2 input terminal A2=0→LUT2 output terminal Y2=1 →LUT1 input terminal A1=1 → LUT1 output terminal Y1=1→LUT2 input terminal A1=1 →LUT2 output terminal Y2=0→LUT1 input terminal A1=0→.... Incidentally, the order of the LUT circuits each outputting the same value as the LUT circuit outputting the inverse does not matter.

Each LUT circuit which outputs the same value is obtained by adjusting the logic value stored in each individual memory cells 21. In FIGS. 2A and 2B, the value stored in the individual memory cell 21ⱼ₁₅ is set to 1, and the value stored in the individual memory cell 21ⱼ₁₆ is set to 0. As another example, in FIGS. 4A and 4B, the value stored in the individual memory cell 21ⱼ₁ is set to 1, and the value stored in the individual memory cell 21ⱼ₂ is set to 0. As a further example, in FIGS. 5A and 5B, the value stored in the individual memory cell 21ⱼ₁ is set to 1, and the value stored in the individual memory cell 21ⱼ₂ is set to 0. It is possible to prepare each non-inverting LUT circuit in this way.

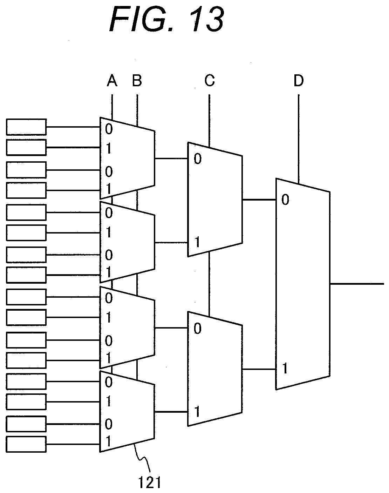

Further, the configuration of the LUT circuit according to the present invention is not limited to the configuration illustrated in the present embodiment. For example, in order to improve load drive capability of the first selection part 23, there are considered configurations in which a tristate buffer is used and an inverting buffer is inserted to the input or output. In this case, there is a case where the input and output of the first selection part 23 are placed in a reverse relationship. The second, third and fourth selection parts 25, 27 and 29 are also similar. Further, there is also considered as the configuration of the LUT circuit, a method in which a plurality of selection parts is configured so as to be integral. As shown in FIG. 13, for example, first and second selection parts 23 and 25 are provided as an integrated selection parts, each of which may be configured so as to select one from logic values stored in four individual memory cells. In this case, the integrated selection parts are controlled by two input terminals corresponding to an input terminal A and an input terminal B. Here, gate circuits included in each integrated selection part may also be controlled by the two input terminals of the input terminal A (one example of "first input terminal" of the present application invention) and the input terminal B (one example of "second input terminal" of the present application invention). For example, each of the integrated selection parts 121 may have four gate circuits 123₁ to 123₄ one of which is brought into an on state according to two inputs (AB)=(00, 01, 10, 11). At this time, if B=0 when oscillating, the two gate circuits 123 corresponding to 00 and 10 are alternately turned on. If B=1 when not oscillating, either one of the two gate circuits 123 corresponding to 01 or 11 is brought into an on state, and the two gate circuits 123 corresponding to 00 and 10 are respectively brought into an off state irrespective of the value of A. Therefore, the suppression of degradation of the gate circuits contributing to the oscillation when not oscillating can be carried out by inputting a suitable value to the input terminal B. A tristate buffer is given as one example of such a gate circuit 123. The present invention is applicable even to LUT circuits having these configurations.

### Reference Signs List

1 ... ring oscillator, 3 ... LUT circuit, 11 ... oscillation storage unit, 13 ... non-oscillation storage unit, 15 ... selection signal unit, 17 ... selector, 21 ... individual memory cells, 22 ... memory part, 23 ... first selection parts, 25 ... second selection parts, 27 ... third selection parts, 29 ... fourth selection part, 31, 33, 35, 37, 39, 45, 47 ... transistors, 41, 43 ... SRAMs, 49 ... inverting buffer.

## Claims

1. A ring oscillator in an FPGA, comprising:
a plurality of LUT circuits (3) as delay elements connected annularly,
a selector circuit (11, 13, 15, 17) configured to apply input logic values to each of the LUT circuits (3);
each of the LUT circuits (3) including:
a memory part (22) having a plurality of individual memory cells (21) respectively storing logic values,
an output terminal connected to the next-stage LUT circuit (3),
a first input terminal (A) connected to an output terminal of the pre-stage LUT circuit (3), and
a plurality of first gate circuits (23),
each of the first gate circuits (23) including:
at least one p-type transistor and at least one n-type transistor,
each of the first gate circuits (23) being brought into an on state or an off state according to the logic value inputted to the first input terminal (A) by the selector circuit (11, 13, 15, 17), and
each of the first gate circuits (23) entering a state of allowing the logic value in one of the individual memory cells (21) or the inverted logic value of the logic value in one of the individual memory cells (21) to pass to the output terminal side in the on state, and a state of not allowing the passage of the logic values stored in the individual memory cells (21) to the output terminal side in the off state,
the LUT circuits (3) including first and second and third LUT circuits connected in order from the input side to the output side,
the second LUT circuit (3) and the third LUT circuit respectively having the same plurality of first gate circuits (23),
**characterized in that** said selector circuit (11, 13, 15, 17) is configured to operate the LUT circuits (3) in an oscillating mode by applying a first set of logic values and to operate the LUT circuits (3) in a non-oscillating mode by applying a second set of logic values,
wherein said second set of logic values is selected depending on whether the degradation of the p-type transistor or the degradation of the n-type transistor shall be suppressed and such that the logic value inputted to the first input terminal (A) of the second LUT circuit (3) and the logic value outputted from the output terminal of the second LUT circuit (3) are the same in order to bring the same part of the first gate circuits (23) into an off state in the second LUT circuit (3) and the third LUT circuit (3) respectively when the LUT circuits (3) are operated in the non-oscillating mode.

2. The ring oscillator according to claim 1, wherein each of the LUT circuits further includes:
a second input terminal (B) different from the first input terminal (A), and
a plurality of second gate circuits (25),
wherein each of the second gate circuits (25) includes at least one p-type transistor and at least one n-type transistor and is brought into an on state or an off state according to the logic value inputted to the second input terminal (B),
wherein each of the second gate circuits (25) enters a state of allowing the logic value in one of the individual memory cells (21) or the inverted logic value of the logic value in one of the individual memory cells (21) to pass to the output terminal side in the on state, and a state of not allowing the passage of the logic values stored in the individual memory cells (21) to the output terminal side in the off state,, and
wherein in the non-oscillating mode, the memory part (22) and the output terminal are connected to each other via a part of the second gate circuits (25) differing from the part of the second gate circuits (25) connecting the memory part (22) and the output terminal when being operated in the oscillating mode by inputting different logic values to the second input terminal of the second LUT circuit in the different operating modes.

3. The ring oscillator according to claim 2, wherein each of the second gate circuits (25) is located closer to the output terminal side than the first gate circuits (23), and enters a state of allowing the logic value allowed to pass by one of the first gate circuits (23) or the inverted logic value of the logic value allowed to pass by one of the first gate circuits (23) to pass to the output terminal side in the on state.

4. The ring oscillator according to claim 2, wherein the first gate circuits (23) and the second gate circuits (25) are not separate circuits but combined gate circuits with a plurality of inputs, and
wherein the gate circuits (23, 25) are respectively brought into an on state or an off state according to the logic value inputted to the first input terminal (A) and the logic value inputted to the second input terminal (B).

5. The ring oscillator according to any of claims 1 to 4, wherein in each of the LUT circuits (3) at least other than the first-stage LUT circuit (3), the individual memory cell connected to the output terminal when not oscillating stores the logic value inputted to the first input terminal (A) when not oscillating.

6. A ring oscillator according to claim 1, further comprising:
a second input terminal (B) different from the first input terminal (A), and
a plurality of second gate circuits (25),
each of the second gate circuits (25) having at least one p-type transistor and at least one n-type transistor and being brought into an on state or an off state according to the logic value inputted to the second input terminal,
each of the second gate circuits (25) entering a state of allowing the logic value in one of the individual memory cells (21) or the inverted logic value of the logic value in one of the individual memory cells (21) to pass to the output terminal side in the on state, and a state of not allowing the passage of the logic values stored in the individual memory cells (21) to the output terminal side in the off state, and
wherein when being operated in the non-oscillating mode, the memory part (22) and the output terminal are connected to each other via a part of the second gate circuits (25) differing from the part of the second gate circuits (25) connecting the memory part (22) and the output terminal when being operated in the oscillating mode by inputting different logic values to the second input terminal in at least the two LUT circuits in the different operating modes.

7. The ring oscillator according to claim 6, wherein the first gate circuits (23, 25, 27, 29; 45, 47) and the second gate circuits (25, 27, 29; 45; 47) are not separate circuits but combined gate circuits with a plurality of input, and
wherein the gate circuits (23, 25, 27, 29; 45; 47) are respectively brought into an on state or an off state according to the logic value inputted to the first input terminal (A) and the logic value inputted to the second input terminal (B).

8. A ring oscillator in an FPGA, comprising:
only a first LUT circuit (3) and a second LUT circuit (3) connected in order from the input side to the output side as delay elements connected annularly,
a selector circuit (11, 13, 15, 17) configured to apply input logic values to each of the LUT circuits (3);
the first LUT circuit (3) and the second LUT circuit (3) each including:
a memory part (22) having a plurality of individual memory cells (21) respectively storing logic values;
an output terminal connected to the next-stage LUT circuit;
a first input terminal (A) connected to the output terminal of the pre-stage LUT circuit; and
a plurality of first gate circuits (23),
each of the first gate circuits (23) having:
at least one p-type transistor and at least one n-type transistor,
each of the first gate circuits (23) being brought into an on state or an off state according to the logic value inputted to the first input terminal (A) by the selector circuit (11, 13, 15, 17), and
each of the first gate circuits (23) entering a state of allowing the logic value in one of the individual memory cells (21) or the inverted logic value of the logic value in one of the individual memory cells (21) to pass to the output terminal side in the on state, and entering a state of not allowing the passage of the logic values stored in the individual memory cells (21) to the output terminal side in the off state, and
the first LUT circuit and the second LUT circuit respectively having the same plurality of first gate circuits (23),
**characterized in that** said selector circuit (11, 13, 15, 17) is configured to operate the LUT circuits (3) in an oscillating mode by applying a first set of logic values and to operate the LUT circuits (3) in a non-oscillating mode by applying a second set of logic values,
wherein said second set of logic values is selected depending on whether the degradation of the p-type transistor or the degradation of the n-type transistor shall be suppressed and such that
the logic value inputted to the first input terminal (A) of the first LUT circuit and the logic value outputted from the output terminal of the first LUT circuit (3) are the same in order to bring the same part of the first gate circuits (23) into an off state in the first LUT circuit (3) and the second LUT circuit (3) respectively when the LUT circuits (3) are operated in the non-oscillating mode.

9. A ring oscillator in an FPGA, comprising:
only one LUT circuit as a delay element,
a selector circuit (11, 13, 15, 17) configured to apply input logic values to of the LUT circuit (3);
the LUT circuit including:
a memory part (22) having a plurality of individual memory cells (21) respectively storing logic values,
an output terminal,
a first input terminal (A) connected to the output terminal,
a plurality of first gate circuits (23),
a second input terminal (B) different from the first input terminal (A), and
a plurality of second gate circuits (25),
each of the first gate circuits (23) having:
at least one p-type transistor and at least one n-type transistor,
each of the first gate circuits being brought into an on state or an off state according to the logic value inputted to the first input terminal (A) by the selector circuit (11, 13, 15, 17), and
each of the first gate circuits (23) entering a state of allowing the logic value in one of the individual memory cells (21) or the inverted logic value of the logic value in one of the individual memory cells (21) to pass to the output terminal side in the on state, and entering a state of not allowing the passage of the logic values stored in the individual memory cells (21) to the output terminal side in the off state, each of the second gate circuits (25) having:
at least one p-type transistor and at least one n-type transistor,
each of the second gate circuits (25) being brought into an on state or an off state according to the logic value inputted to the second input terminal (B) by the selector circuit (11, 13, 15, 17), and
each of the second gate circuits (25) entering a state of allowing the logic value in one of the individual memory cells (21) or the inverted logic value of the logic value in one of the individual memory cells (21) to pass to the output terminal side in the on state, and entering a state of not allowing the passage of the logic values stored in the individual memory cells (21) to the output terminal side in the off state,
**characterized in that** said selector circuit (11, 13, 15, 17) is configured to operate the LUT circuit (3) in an oscillating mode by applying a first set of logic values and to operate the LUT circuit (3) in a non-oscillating mode by applying a second set of logic values,
wherein said second set of logic values is selected depending on whether the degradation of the p-type transistor or the degradation of the n-type transistor shall be suppressed and such that when being operated in the non-oscillating mode, the memory part (22) and the output terminal are connected to each other via a part of the second gate circuits (25) differing from the part of the second gate circuits (25) of connecting the memory part (22) and the output terminal when being operated in the oscillating mode by inputting different logic values to the second input terminal in the different operating modes.

10. A sensor which measures a frequency, a temperature, a voltage or the degree of variation in production and is equipped with the ring oscillator according to any of claims 1 to 9.

11. A control method of a ring oscillator in an FPGA, wherein:
the ring oscillator has a plurality of LUT circuits as delay elements connected annularly,
each of the LUT circuits including:
a memory part (22) having a plurality of individual memory cells (21) respectively storing logic values,
an output terminal connected to the next-stage LUT circuit,
a first input terminal (A) connected to an output terminal of the pre-stage LUT circuit, and
a plurality of first gate circuits (23),
each of the first gate circuits (23) having:
at least one p-type transistor and at least one n-type transistor,
each of the first gate circuits (23) being brought into an on state or an off state according to the logic value inputted to the first input terminal (A), and
each of the first gate circuits (23) entering a state of allowing the logic value in one of the individual memory cells (21) or the inverted logic value of the logic value in one of the individual memory cells (21) to pass to the output terminal side in the on state, and entering a state of not allowing the passage of the logic values stored in the individual memory cells (21) to the output terminal side in the off state,
the LUT circuits including first, second and third LUT circuits connected in order from the input side to the output side, and
the second LUT circuit and the third LUT circuit respectively having the same plurality of first gate circuits (23),
**characterized in that** methods includes operating the LUT circuits (3) in an oscillating mode by applying a first set of logic values and to operating the LUT circuits (3) in a non-oscillating mode by applying a second set of logic values,
wherein said second set of logic values is selected depending on whether the degradation of the p-type transistor or the degradation of the n-type transistor shall be suppressed and such that
when not oscillating, the same first gate circuits (23) are brought into an off state in the second LUT circuit and the third LUT circuit by making identical the logic value inputted to the first input terminal (A) of the second LUT circuit and the logic value outputted from the output terminal of the second LUT circuit.

12. The control method of the ring oscillator according to claim 11, wherein each of the LUT circuits further including a second input terminal different from the first input terminal (A), and a plurality of second gate circuits (25),
wherein each of the second gate circuits (25) including a p-type transistor and an n-type transistor and being brought into an on state or an off state according to the logic value inputted to the second input terminal,
wherein each of the second gate circuits (25) entering a state of allowing the logic value in one of the individual memory cells (21) or the inverted logic value of the logic value in one of the individual memory cells (21) to pass to the output terminal side in the on state, and entering a state of not allowing the passage of the logic values stored in the individual memory cells (21) to the output terminal side in the off state,
wherein the second gate circuits (25) respectively include p-type transistors and n-type transistors, and
the control method including a step of when not oscillating, the memory part (22) and the output terminal being connected to each other via a different part of the second gate circuits (25) from the part of the second gate circuits (25) capable of connecting the memory part (22) and the output terminal when oscillating by inputting the logic value different from the logic value inputted to the second input terminal of the second LUT circuit when oscillating to the second input terminal.

13. The control method of the ring oscillator according to claim 11 or 12, wherein the individual memory cell connected to the output terminal when not oscillating storing the logic value inputted to the first input terminal (A) when not oscillating in each of the LUT circuits at least other than the first-stage LUT circuit.

14. A control method of a ring oscillator according to claim 11, wherein:
the ring oscillator has a second input terminal (B) different from the first input terminal (A), and
a plurality of second gate circuits (25),each of the second gate circuits (25) including at least one p-type transistor and at least one n-type transistor and being brought into an on state or an off state according to the logic value inputted to the second input terminal (B),
each of the second gate circuits (25) entering a state of allowing the logic value in one of the individual memory cells (21) or the inverted logic value of the logic value in one of the individual memory cells (21) to pass to the output terminal side in the on state, and entering a state of not allowing the passage of the logic values stored in the individual memory cells (21) to the output terminal side in the off state,
the second gate circuits (25) having p-type transistors and n-type transistors respectively, and
wherein when not oscillating, the memory part (22) and the output terminal being connected to each other via a different part of the second gate circuits (25) from the part of the second gate circuits (25) capable of connecting the memory part (22) and the output terminal when oscillating by inputting the logic value different from the logic value inputted to the second input terminal when oscillating to the second input terminal in at least the two LUT circuits of the LUT circuits.

## Patentansprüche

1. Ringoszillator in einem FPGA (Field Programmable Gate Array) mit:
einer Mehrzahl von LUT(Look-Up Table)-Schaltkreisen (3) als ringförmig verbundenen Verzögerungselementen,
einer Auswahlschaltung (11, 13, 15, 17), die ausgestattet ist, um jedem der LUT-Schaltkreise (3) logische Eingabewerte zuzuführen,
wobei jeder der LUT-Schaltkreise (3) aufweist:
einen Speicherbereich (22) mit einer Mehrzahl einzelner Speicherzellen (21), die jeweils logische Werte speichern,
einen Ausgangsanschluss, der mit dem LUT-Schaltkreis (3) der nächsten Stufe verbunden ist,
einen ersten Eingangsanschluss (A), der mit einem Ausgangsanschluss des LUT-Schaltkreises (3) der Vorstufe verbunden ist,
und
eine Mehrzahl erster Torschaltungen (23),
wobei jede der ersten Torschaltungen (23) umfasst:
mindestens einen p-leitenden Transistor und mindestens einen n-leitenden Transistor,
wobei jede der ersten Torschaltungen (23) entsprechend dem logischen Wert, der dem ersten Eingangsanschluss (A) durch die Auswahlschaltung (11, 13, 15, 17) eingegeben wurde, in einen "An"-Zustand oder in einen "Aus"-Zustand versetzt wird, und
jede der Torschaltungen (23) einen Zustand einnimmt, der es dem logischen Wert in einer der einzelnen Speicherzellen (21) oder dem inversen logischen Wert des logischen Wert in einer der einzelnen Speicherzellen (21) ermöglicht, zu der Ausganganschlussseite in dem "An"-Zustand überzugehen, und einen Zustand, in dem der Übergang der in den einzelnen Speicherzellen (21) gespeicherten logischen Werte zu der Ausgangsanschlussseite in dem "Aus"-Zustand nicht erlaubt wird,
wobei die LUT-Schaltkreise (3) einen ersten, einen zweiten und einen dritten LUT-Schaltkreis umfassen, die in dieser Reihenfolge von der Eingangsseite zu der Ausgangsseite angeschlossen sind,
wobei der zweite LUT-Schaltkreis (3) und der dritte LUT-Schaltkreis jeweils die gleiche Vielzahl von ersten Torschaltungen (23) aufweisen,
**dadurch gekennzeichnet, dass** die Auswahlschaltung (11, 13, 14, 17) so ausgebildet ist, dass sie die LUT-Schaltkreise (3) in einem oszillierenden Modus betreibt durch Anwenden eines ersten Satzes logischer Werte, und dass sie die LUT-Schaltkreise (3) in einem nicht-oszillierenden Modus betreibt durch Anwenden eines zweiten Satzes logischer Werte,
wobei der zweite Satz logischer Werte danach ausgewählt wird, ob die Funktionsminderung des p-leitenden Transistors oder die Funktionsminderung des n-leitenden Transistors unterbunden werden soll, und derart, dass der in dem ersten Eingangsanschluss (A) des zweiten LUT-Schaltkreises (3) eingegebene logische Wert und der von dem Ausgangsanschluss des zweiten LUT-Schaltkreises (3) ausgegebene logische Wert gleich sind, um den gleichen Teil der ersten Torschaltungen (23) in dem zweiten LUT-Schaltkreis (3) bzw. in dem dritten LUT-Schaltkreis (3) in einen "Aus"-Zustand zu versetzen, wenn die LUT-Schaltkreise (3) in dem nicht-oszillierenden Modus betrieben werden.

2. Ringoszillator nach Anspruch 1, wobei jeder der LUT-Schaltkreise ferner umfasst:
einen zweiten, von dem ersten Eingangsanschluss (A) verschiedenen Eingangsanschluss (B), und
eine Mehrzahl zweiter Torschaltungen (25),
wobei jede der zweiten Torschaltungen (25) mindestens einen p-leitenden Transistor und mindestens einen n-leitenden Transistor aufweist, und in Übereinstimmung mit dem dem zweiten Eingangsanschluss (B) zugeführten logischen Wert in einen "An"-Zustand oder in einen "Aus"-Zustand versetzt wird,
wobei jede der zweiten Torschaltungen (25) in einen Zustand gelangt, der es dem logischen Wert in einer der einzelnen Speicherzellen (21) oder dem inversen logischen Wert des logischen Wertes in einer der einzelnen Speicherzellen (21) erlaubt, zu der Ausgangsanschlussseite in dem "An"-Zustand überzugehen, und in einen Zustand, der den Übergang der in den einzelnen Speicherzellen (21) gespeicherten logischen Werte auf die Ausgangsanschlussseite in dem "Aus"-Zustand nicht erlaubt, und
wobei in dem nicht-oszillierenden Modus der Speicherteil (22) und der Ausgangsanschluss über einen Teil der zweiten Torschaltungen (25) miteinander verbunden sind, die sich von dem Teil der zweiten Torschaltungen (25), die den Speicherteil (22) und den Ausgangsanschluss miteinander verbinden, wenn diese in dem oszillierenden Modus betrieben werden, unterscheiden, durch Eingeben verschiedener logischer Werte an den zweiten Eingangsanschluss des zweiten LUT-Schaltkreises in den verschiedenen Betriebsmodi.

3. Ringoszillator nach Anspruch 2, wobei jede der zweiten Torschaltungen (25) näher an der Ausgangsanschlussseite als die ersten Torschaltungen (23) angeordnet ist, und in einen Zustand gelangt, der es dem logischen Wert, der durch eine der ersten Torschaltungen (23) passieren kann, oder dem inversen logischen Wert des logischen Werts, der durch eine der ersten Torschaltungen (23) passieren kann, erlaubt, in dem "An"-Zustand auf die Ausgangsanschlussseite überzugehen.

4. Ringoszillator nach Anspruch 2, wobei die ersten Torschaltungen (23) und die zweiten Torschaltungen (24) nicht getrennte Schaltkreise sind, sondern kombinierte Torschaltungen mit einer Mehrzahl von Eingängen, und
wobei die Torschaltungen (23, 25) jeweils in einen "An"-Zustand oder in einen "Aus"-Zustand versetzt werden gemäß dem logischen Wert, der dem ersten Eingangsanschluss (A) zugeführt wird, und dem logischen Wert, der dem zweiten Eingangsanschluss (B) zugeführt wird.

5. Ringoszillator nach einem der Ansprüche 1 bis 4, wobei in jedem der LUT-Schaltkreise (3), der mindestens verschieden von dem LUT-Schaltkreis (3) der ersten Stufe ist, die einzelne Speicherzelle, die in dem nicht-oszillierenden Modus mit dem Ausgangsanschluss verbunden ist, den logischen Wert speichert, der im nicht-oszillierenden Modus dem ersten Eingangsanschluss (A) zugeführt wird.

6. Ringoszillator nach Anspruch 1, der ferner aufweist:
einen zweiten Eingangsanschluss (B), der von dem ersten Eingangsanschluss (A) verschieden ist, und
eine Mehrzahl zweiter Torschaltungen (25),
wobei jede der zweiten Torschaltungen (25) mindestens einen p-leitenden Transistor und mindestens einen n-leitenden Transistor aufweist, und entsprechend dem dem zweiten Eingangsanschluss zugeführten logischen Wert in einen "An"-Zustand oder in einen "Aus"-Zustand versetzt wird,
wobei jede der zweiten Torschaltungen (25) in einen Zustand gelangt, der es dem logischen Wert in einer der einzelnen Speicherzellen (21) oder dem inversen logischen Wert des logischen Werts in einer der einzelnen Speicherzellen (21) erlaubt, in dem "An"-Zustand auf die Ausgangsanschlussseite überzugehen, und in einen Zustand, der den Übergang der logischen Werte, die in den einzelnen Speicherzellen (21) gespeichert sind, auf die Ausgangsanschlussseite in dem "Aus"-Zustand nicht erlaubt, und
wobei bei einem Betrieb in dem nicht-oszillierenden Modus der Speicherteil (22) und der Ausgangsanschluss miteinander über einen Teil der zweiten Torschaltungen (25) verbunden sind, die sich von dem Teil der zweiten Torschaltungen (25) unterscheiden, die den Speicherteil (22) und den Ausgangsanschluss beim Betrieb in dem oszillierenden Modus verbinden, durch Zuführen verschiedener logischer Werte zu dem zweiten Eingangsanschluss in mindestens den zwei LUT-Schaltkreisen in den verschiedenen Betriebsmodi.

7. Ringoszillator nach Anspruch 6, wobei die ersten Torschaltungen (23, 25, 27, 29; 45, 47) und die zweiten Torschaltungen (25, 27, 29; 45, 47) nicht getrennte Schaltkreise sind, sondern kombinierte Torschaltungen mit einer Mehrzahl von Eingängen, und
wobei die Torschaltungen (23, 25, 27, 29; 45, 47) jeweils in einem "An"-Zustand oder in einem "Aus"-Zustand sind entsprechend dem logischen Wert, der dem ersten Eingangsanschluss (A) zugeführt wird, und dem logischen Wert, der dem zweiten Eingangsanschluss (B) zugeführt wird.

8. Ringoszillator in einem FPGA (Field Programmable Gate Array) mit:
nur einem ersten LUT(Look-Up Table)-Schaltkreis (3) und einem zweiten LUT-Schaltkreis (3), die von der Eingangsseite zu der Ausgangsseite in dieser Reihenfolge anschlossen sind, als ringförmig verbundene Verzögerungselemente,
einer Auswahlschaltung (11, 13, 15, 17), die ausgebildet ist, um logische Eingangswerte jedem der LUT-Schaltkreise (3) zuzuführen,
wobei der erste LUT-Schaltkreis (3) und der zweite LUT-Schaltkreis (3) jeweils aufweisen:
einen Speicherteil (22) mit einer Mehrzahl einzelner Speicherzellen (21), die jeweils logische Werte speichern,
einen Ausgangsanschluss, der mit dem LUT-Schaltkreis der nächsten Stufe verbunden ist,
einen ersten Eingangsanschluss (A), der mit dem Ausgangsanschluss des LUT-Schaltkreises der Vorstufe verbunden ist, und
eine Mehrzahl erster Torschaltungen (23),
wobei jede der Torschaltungen (23) aufweist:
mindestens einen p-leitenden Transistor und mindestens einen n-leitenden Transistor, wobei jede der ersten Torschaltungen (23) in einen "An"-Zustand oder in einen "Aus"-Zustand versetzt wird, gemäß dem logischen Wert, der dem ersten Eingangsanschluss (A) durch die Auswahlschaltung (11, 13, 15, 17) zugeführt wird, und
wobei jede der ersten Torschaltungen (23) einen Zustand einnimmt, der es dem logischen Wert in einer der einzelnen Speicherzellen (21) oder dem inversen logischen Wert des logischen Werts in einer der einzelnen Speicherzellen (21) erlaubt, auf die Ausgangsanschlussseite in den "An"-Zustand überzugehen, und einen Zustand einnimmt, in dem der Übergang der in den einzelnen Speicherzellen (21) gespeicherten logischen Werte auf die Ausgangsanschlussseite in dem "Aus"-Zustand nicht erlaubt wird, und
wobei der erste LUT-Schaltkreis und der zweite LUT-Schaltkreis jeweils die gleiche Mehrzahl an ersten Vorschaltungen (23) aufweisen,
**dadurch gekennzeichnet, dass** die Auswahlschaltung (11, 13, 15, 17) so ausgebildet ist, dass sie die LUT-Schaltkreise (3) in einem oszillierenden Modus betreibt durch Anwenden eines ersten Satzes logischer Werte, und dass sie die LUT-Schaltkreise (3) in einem nicht-oszillierenden Modus zu betreibt durch Anwenden eines zweiten Satzes logischer Werte,
wobei der zweite Satz logischer Werte ausgewählt wird in Abhängigkeit davon, ob die Funktionsminderung des p-leitenden Transistors oder die Funktionsminderung des n-leitenden Transistors unterbunden werden soll, und derart, dass
der dem ersten Eingangsanschluss (A) des ersten LUT-Schaltkreises zugeführte logische Wert und der von dem Ausgangsanschluss des ersten LUT-Schaltkreises (3) ausgegebene logische Wert gleich sind, um den gleichen Teil der ersten Torschaltung (23) in dem ersten LUT-Schaltkreis (3) und in dem zweiten LUT-Schaltkreis (3) jeweils in einen Aus-Zustand zu versetzen, wenn die LUT-Schaltkreise (3) in dem nicht-oszillierenden Modus betrieben werden.

9. Ringoszillator in einem FPGA (Field Programmable Gate Array) mit:
nur einem LUT(Look-Up Table)-Schaltkreis als einem Verzögerungselement,
einer Auswahlschaltung (11, 13, 15, 17), die ausgebildet ist, um logische Eingangswerte an den LUT-Schaltkreis (3) anzulegen,
wobei der LUT-Schaltkreis aufweist:
einen Speicherteil (22) mit einer Mehrzahl einzelner Speicherzellen (21), die jeweils logische Werte speichern,
einen Ausgangsanschluss,
einen ersten Eingangsanschluss (A), der mit dem Ausgangsanschluss verbunden ist,
eine Mehrzahl erster Torschaltungen (23),
einen zweiten Eingangsanschluss (B), der von dem ersten Eingangsanschluss (A) verschieden ist, und
eine Mehrzahl zweiter Torschaltungen (25), wobei jede der ersten Torschaltungen (23) aufweist:
mindestens einen p-leitenden Transistor und mindestens einen n-leitenden Transistor, wobei jeder der ersten Torschaltungen in einen "An"-Zustand oder in einen "Aus"-Zustand versetzt wird gemäß dem logischen Wert, der dem ersten Eingangsanschluss (A) durch die Auswahlschaltung (11, 13, 15, 17) zugeführt wird, und
wobei jede der ersten Torschaltungen (23) in einen Zustand eintritt, der es dem logischen Wert in einer der einzelnen Speicherzellen (21) oder dem inversen logischen Wert des logischen Werts in einer der einzelnen Speicherzellen (21) erlaubt, auf die Ausgangsanschlussseite in den "An"-Zustand überzugehen, und in einen Zustand eintritt, bei dem der Übergang der in den einzelnen Speicherzellen (21) gespeicherten logischen Werte auf die Ausgangsanschlussseite in dem "Aus"-Zustand nicht erlaubt wird,
wobei jede der zweiten Torschaltungen (25) aufweist:
mindestens einen p-leitenden Transistor und mindestens einen n-leitenden Transistor,
wobei jede der zweiten Torschaltungen (25) in einen "An"-Zustand oder in einen "Aus"-Zustand versetzt wird gemäß dem logischen Wert, der dem zweiten Eingangsanschluss (B) durch die Auswahlschaltung (11, 13, 15, 17) zugeführt wird, und
wobei jede der zweiten Torschaltungen (25) in einen Zustand eintritt, bei dem es dem logischen Wert in einer der einzelnen Speicherzellen (21) oder dem inversen logischen Wert des logischen Werts in einer der einzelnen Speicherzellen (21) erlaubt wird, auf die Ausgangsanschlussseite in dem "An"-Zustand überzugehen, und in einen Zustand eintritt, in dem der Übergang der in den einzelnen Speicherzellen (21) gespeicherten logischen Werte auf die Ausgangsanschlussseite in dem "Aus"-Zustand nicht erlaubt wird,
**dadurch gekennzeichnet, dass** die Auwahlschaltung (11, 13, 15, 17) so ausgebildet ist, dass sie den LUT-Schaltkreis (3) in einem oszillierenden Modus betreibt durch Anwenden eines ersten Satzes logischer Werte, und dass sie den LUT-Schaltkreis (3) in einem nicht-oszillierenden Modus betreibt durch Anwenden eines zweiten Satzes logischer Werte,
wobei der zweite Satz logischer Werte ausgewählt wird in Abhängigkeit davon, ob die Funktionsminderung des p-leitenden Transistors oder die Funktionsminderung des n-leitenden Transistors unterbunden werden soll, und derart, dass bei dem Betrieb in dem nicht-oszillierenden Modus der Speicherteil (22) und der Ausgangsanschluss miteinander über einen Teil der zweiten Torschaltung (25) verbunden sind, der sich von dem Teil der zweiten Torschaltung (25) unterscheidet, der den Speicherteil (22) und den Ausgangsanschluss bei dem Betrieb in dem oszillierenden Modus verbindet, durch Zuführen verschiedener logischer Werte zu dem zweiten Eingangsanschluss in den verschiedenen Betriebsmodi.

10. Sensor, der eine Frequenz, eine Temperatur, eine Spannung oder den Grad einer Produktionsänderung misst, und der mit einem Ringoszillator nach einem der Ansprüche 1 bis 9 ausgerüstet ist.

11. Verfahren zur Steuerung eines Ringoszillators in einem FPGA (Field Programmable Gate Array), wobei
der Ringoszillator eine Mehrzahl von LUT(Look-Up Table)-Schaltkreisen (3) als ringförmig verbundene Verzögerungselemente aufweist,
wobei jeder der LUT-Schaltkreise aufweist:
einen Speicherbereich (22) mit einer Mehrzahl einzelner Speicherzellen (21), die jeweils logische Werte speichern,
einen Ausgangsanschluss, der mit dem LUT-Schaltkreis (3) der nächsten Stufe verbunden ist,
einen ersten Eingangsanschluss (A), der mit einem Ausgangsanschluss des LUT-Schaltkreises (3) der Vorstufe verbunden ist,
und
eine Mehrzahl erster Torschaltungen (23),
wobei jede der ersten Torschaltungen (23) umfasst:
mindestens einen p-leitenden Transistor und mindestens einen n-leitenden Transistor,
wobei jede der ersten Torschaltungen (23) entsprechend dem logischen Wert, der dem ersten Eingangsanschluss (A) durch die Auswahlschaltung (11, 13, 15, 17) eingegeben wurde, in einen "An"-Zustand oder in einen "Aus"-Zustand versetzt wird, und
jede der Torschaltungen (23) einen Zustand einnimmt, der es dem logischen Wert in einer der einzelnen Speicherzellen (21) oder dem inversen logischen Wert des logischen Wert in einer der einzelnen Speicherzellen (21) ermöglicht, zu der Ausgangsanschlussseite in dem "An"-Zustand überzugehen, und einen Zustand, in dem der Übergang der in den einzelnen Speicherzellen (21) gespeicherten logischen Werte zu der Ausgangsanschlussseite in dem "Aus"-Zustand nicht erlaubt wird,
wobei die LUT-Schaltkreise einen ersten, einen zweiten und einen dritten LUT-Schaltkreis umfassen, die in dieser Reihenfolge von der Eingangsseite zu der Ausgangsseite angeschlossen sind,
wobei der zweite LUT-Schaltkreis und der dritte LUT-Schaltkreis jeweils die gleiche Vielzahl von ersten Torschaltungen (23) aufweisen,
**dadurch gekennzeichnet, dass** das Verfahren den Betrieb der LUT-Schaltkreise (3) in einem oszillierenden Modus umfasst durch Anwenden eines ersten Satzes logischer Werte, und das den Betrieb der LUT-Schaltkreise (3) in einem nicht-oszillierenden Modus umfasst durch Anwenden eines zweiten Satzes logischer Werte,
wobei der zweite Satz logischer Werte danach ausgewählt wird, ob die Funktionsminderung des p-leitenden Transistors oder die Funktionsminderung des n-leitenden Transistors unterbunden werden soll, und derart, dass
in dem nicht-oszillierenden Modus die gleichen ersten Torschaltungen (23) in dem zweiten LUT-Schaltkreis und dem dritten LUT-Schaltkreis in einen "Aus"-Zustand versetzt werden durch Gleichmachen des logischen Wertes, der dem ersten Eingangsanschluss (A) des zweiten LUT-Schaltkreises zugeführt wird, und des logischen Wertes, der von dem Ausgangsanschluss des zweiten LUT-Schaltkreises ausgegeben wird.

12. Verfahren zur Steuerung des Ringoszillators nach Anspruch 11,
wobei jeder der LUT-Schaltkreise ferner einen zweiten Eingangsanschluss aufweist, der von dem ersten Eingangsanschluss (A) verschieden ist, und eine Mehrzahl zweiter Torschaltungen (25),
wobei jede der zweiten Torschaltungen (25) einen p-leitenden Transistor und einen n-leitenden Transistor aufweist, und in einen "An"-Zustand oder in einen "Aus"-Zustand versetzt wird gemäß dem dem zweiten Eingangsanschluss zugeführten logischen Wert,
wobei jede der zweiten Torschaltungen (25) in einen Zustand eintritt, bei dem es dem logischen Wert in einer der einzelnen Speicherzellen (21) oder dem inversen logischen Wert des logischen Werts in einer der einzelnen Speicherzellen (21) erlaubt wird, auf die Ausgangsanschlussseite in dem "An"-Zustand überzugehen, und in einen Zustand eintritt, bei dem der Übergang des logischen Wertes, der in den einzelnen Speicherzellen (21) gespeichert ist, zu der Ausgangsanschlussseite in dem "Aus"-Zustand nicht erlaubt wird,
wobei die zweiten Torschaltungen (25) jeweils p-leitende Transistoren und n-leitende Transistoren aufweisen, und
das Steuerungsverfahren einen Schritt aufweist, bei dem in dem nicht-oszillierenden Modus der Speicherteil (22) und der Ausgangsanschluss miteinander über einen Teil der zweiten Torschaltungen (25) verbunden sind, der verschieden ist von dem Teil der zweiten Torschaltungen (25), der den Speicherteil (22) und den Ausgangsanschluss im oszillierenden Modus verbinden kann durch Eingeben des logischen Wertes, der von dem logischen Wert verschieden ist, der dem zweiten Eingangsanschluss des zweiten LUT-Schaltkreises im oszillierenden Modus zugeführt wird, in den zweiten Eingangsanschluss.

13. Steuerungsverfahren des Ringoszillators nach Anspruch 11 oder 12, wobei die einzelne Speicherzelle, die in dem nicht-oszillierenden Modus mit dem Ausgangsanschluss verbunden ist, den logischen Wert speichert, der im nicht-oszillierenden Modus dem ersten Eingangsanschluss (A) in jedem der LUT-Schaltkreise, der mindestens von dem LUT-Schaltkreis der ersten Stufe verschieden ist, zugeführt wird.

14. Steuerungsverfahren eines Ringoszillators nach Anspruch 11, wobei
der Ringoszillator einen zweiten Eingangsanschluss (B) aufweist, der von dem ersten Eingangsanschluss (A) verschieden ist, und
der Ringoszillator eine Mehrzahl zweiter Torschaltungen (25) aufweist, wobei jede der zweiten Torschaltungen (25) mindestens einen p-leitenden Transistor und mindestens einen n-leitenden Transistor aufweist, und in einen "An"-Zustand oder in einen "Aus"-Zustand versetzt wird gemäß dem logischen Wert, der dem zweiten Eingangsanschluss (B) zugeführt wird,
wobei jeder der zweiten Torschaltungen (25) in einen Zustand eintritt, bei dem es dem logischen Wert in einer der einzelnen Speicherzellen (21) oder dem inversen logischen Wert des logischen Werts in einer der einzelnen Speicherzellen (21) erlaubt wird, auf die Ausgangsanschlussseite in dem "An"-Zustand überzugehen, und in einen Zustand eintritt, bei dem der Übergang der in den einzelnen Speicherzellen (21) gespeicherten logischen Werte auf die Ausgangsanschlussseite in dem "Aus"-Zustand nicht erlaubt wird,
wobei die zweiten Torschaltungen (25) p-leitende Transistoren und n-leitende Transistoren aufweisen, und
wobei im nicht-oszillierenden Modus der Speicherteil (22) und der Ausgangsanschluss miteinander über einen Teil der zweiten Torschaltungen (25) verbunden sind, der verschieden ist von dem Teil der zweiten Torschaltungen (25), die den Speicherteil (22) und den Ausgangsanschluss im oszillierenden Modus verbinden können, durch Eingeben des logischen Wertes, der von dem logischen Wert verschieden ist, der im oszillierenden Modus dem zweiten Eingangsanschluss zugeführt wird, in den zweiten Eingangsanschluss in den mindestens zwei LUT-Schaltkreisen der LUT-Schaltkreise.

## Revendications

1. Oscillateur en anneau dans un FPGA, comprenant :
une pluralité de circuits (3) de LUT comme éléments de retard connectés annulairement,
un circuit (11, 13, 15, 17) de sélecteur configuré pour appliquer des valeurs logiques d'entrée à chacun des circuits (3) de LUT ;
chacun des circuits (3) de LUT incluant :
une partie (22) de mémoire ayant une pluralité de cellules (21) de mémoire individuelles stockant respectivement des valeurs logiques,
une borne de sortie connectée au circuit (3) de LUT d'étage suivant,
une première borne (A) d'entrée connectée à une borne de sortie du circuit (3) de LUT d'étage précédent, et
une pluralité de premiers circuits (23) de porte,
chacun des premiers circuits (23) de porte incluant :
au moins un transistor de type p et au moins un transistor de type n,
chacun des premiers circuits (23) de porte étant mis dans un état activé ou un état désactivé en fonction de la valeur logique entrée à la première borne (A) d'entrée par le circuit (11, 13, 15, 17) de sélecteur, et
chacun des premiers circuits (23) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé et dans un état pour ne pas permettre le passage des valeurs logiques stockées dans les cellules (21) de mémoire individuelles jusqu'au côté borne de sortie dans l'état désactivé,
les circuits (3) de LUT incluant des premier et deuxième et troisième circuits de LUT connectés dans l'ordre du côté entrée au côté sortie,
le deuxième circuit (3) de LUT et le troisième circuit de LUT ayant respectivement la même pluralité de premiers circuits (23) de porte,
**caractérisé en ce que** ledit circuit (11, 13, 15, 17) de sélecteur est configuré pour faire fonctionner les circuits (3) de LUT dans un mode oscillatoire en appliquant un premier ensemble de valeurs logiques et pour faire fonctionner les circuits (3) de LUT dans un mode non oscillatoire en appliquant un deuxième ensemble de valeurs logiques,
dans lequel ledit deuxième ensemble de valeurs logiques est choisi selon que la dégradation du transistor de type p ou la dégradation du transistor de type n sera supprimée et de telle manière que la valeur logique entrée à la première borne (A) d'entrée du deuxième circuit (3) de LUT et la valeur logique délivrée en sortie de la borne de sortie du deuxième circuit (3) de LUT sont la même de manière à mettre la même partie des premiers circuits (23) de porte dans un état désactivé dans le deuxième circuit (3) de LUT et le troisième circuit (3) de LUT respectivement lorsque les circuits (3) de LUT fonctionnent dans le mode non oscillatoire.

2. Oscillateur en anneau selon la revendication 1, dans lequel chacun des circuits de LUT inclut en outre :
une deuxième borne (B) d'entrée différente de la première borne (A) d'entrée, et
une pluralité de deuxièmes circuits (25) de porte,
dans lequel chacun des deuxièmes circuits (25) de porte inclut au moins un transistor de type p et au moins un transistor de type n et est mis dans un état activé ou un état désactivé en fonction de la valeur logique entrée à la deuxième borne (B) d'entrée,
dans lequel chacun des deuxièmes circuits (25) de porte entre dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé et un état pour ne pas permettre le passage des valeurs logiques stockées dans les cellules (21) de mémoire individuelles jusqu'au côté borne de sortie dans l'état désactivé, et
dans lequel, dans le mode non oscillatoire, la partie (22) de mémoire et la borne de sortie sont connectées l'une à l'autre par l'intermédiaire d'une partie des deuxièmes circuits (25) de porte différente de la partie des deuxièmes circuits (25) de porte connectant la partie (22) de mémoire et la borne de sortie lors d'un fonctionnement dans le mode oscillatoire en entrant une valeur logique différente à la deuxième borne d'entrée du deuxième circuit de LUT dans les différents modes de fonctionnement.

3. Oscillateur en anneau selon la revendication 2, dans lequel chacun des deuxièmes circuits (25) de porte est situé plus près du côté borne de sortie que les premiers circuits (23) de porte, et entre dans un état pour permettre à la valeur logique de passer par un des premiers circuits (23) de porte ou à la valeur logique inversée de la valeur logique laissée passer par un des premiers circuits (23) de porte de passer jusqu'au côté borne de sortie dans l'état activé.

4. Oscillateur en anneau selon la revendication 2, dans lequel les premiers circuits (23) de porte et les deuxièmes circuits (25) de porte ne sont pas des circuits séparés mais des circuits de porte combinés avec une pluralité d'entrées, et
dans lequel les circuits (23, 25) de porte sont respectivement mis dans un état activé ou un état désactivé en fonction de la valeur logique entrée à la première borne (A) d'entrée et de la valeur logique entrée à la deuxième borne (B) d'entrée.

5. Oscillateur en anneau selon l'une quelconque des revendications 1 à 4, dans lequel, dans chacun des circuits (3) de LUT au moins autre que le circuit (3) de LUT de premier étage, la cellule de mémoire individuelle connectée à la borne de sortie en l'absence d'oscillation stocke la valeur logique entrée à la première borne (A) d'entrée en l'absence d'oscillation.

6. Oscillateur en anneau selon la revendication 1, comprenant en outre :
une deuxième borne (B) d'entrée différente de la première borne (A) d'entrée, et
une pluralité de deuxièmes circuits (25) de porte,
chacun des deuxièmes circuits (25) de porte ayant au moins un transistor de type p et au moins un transistor de type n et étant mis dans un état activé ou un état désactivé en fonction de la valeur logique entrée à la deuxième borne d'entrée,
chacun des deuxièmes circuits (25) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé, et dans un état pour ne pas permettre le passage des valeurs logiques stockées dans les cellules (21) de mémoire individuelles jusqu'au côté borne de sortie dans l'état désactivé, et
dans lequel, en fonctionnement dans le mode non oscillatoire, la partie (22) de mémoire et la borne de sortie sont connectées l'une à l'autre par l'intermédiaire d'une partie des deuxièmes circuits (25) de porte différente de la partie des deuxièmes circuits (25) de porte connectant la partie (22) de mémoire et la borne de sortie lors d'un fonctionnement dans le mode oscillatoire en entrant des valeurs logiques différentes à la deuxième borne d'entrée dans au moins les deux circuits de LUT dans les différents modes de fonctionnement.

7. Oscillateur en anneau selon la revendication 6, dans lequel les premiers circuits (23, 25, 27, 29 ; 45, 47) de porte et les deuxièmes circuits (25, 27, 29 ; 45, 47) de porte ne sont pas des circuits séparés mais des circuits de porte combinés avec une pluralité d'entrées, et
dans lequel les circuits (23, 25, 27, 29 ; 45, 47) de porte sont respectivement mis dans un état activé ou un état désactivé en fonction de la valeur logique entrée à la première borne (A) d'entrée et de la valeur logique entrée à la deuxième borne (B) d'entrée.

8. Oscillateur en anneau dans un FPGA, comprenant :
uniquement un premier circuit (3) de LUT et un deuxième circuit (3) de LUT connectés dans l'ordre du côté entrée au côté sortie comme éléments de retard connectés annulairement,
un circuit (11, 13, 15, 17) de sélecteur configuré pour appliquer des valeurs logiques d'entrée à chacun des circuits (3) de LUT ;
le premier circuit (3) de LUT et le deuxième circuit (3) de LUT incluant chacun :
une partie (22) de mémoire ayant une pluralité de cellules (21) de mémoire individuelles stockant respectivement des valeurs logiques ;
une borne de sortie connectée au circuit de LUT d'étage suivant ;
une première borne (A) d'entrée connectée à la borne de sortie du circuit de LUT d'étage précédent, et
une pluralité de premiers circuits (23) de porte,
chacun des premiers circuits (23) de porte ayant :
au moins un transistor de type p et au moins un transistor de type n,
chacun des premiers circuits (23) de porte étant mis dans un état activé ou un état désactivé en fonction de la valeur logique entrée à la première borne (A) d'entrée par le circuit (11, 13, 15, 17) de sélecteur, et
chacun des premiers circuits (23) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé, et entrant dans un état pour ne pas permettre le passage des valeurs logiques stockées dans les cellules (21) de mémoire individuelles jusqu'au côté borne de sortie dans l'état désactivé, et
le premier circuit de LUT et le deuxième circuit de LUT ayant respectivement la même pluralité de circuits (23) de porte,
**caractérisé en ce que** ledit circuit (11, 13, 15, 17) de sélecteur est configuré pour faire fonctionner les circuits (3) de LUT dans un mode oscillatoire en appliquant un premier ensemble de valeurs logiques et pour faire fonctionner les circuits (3) de LUT dans un mode non oscillatoire en appliquant un deuxième ensemble de valeurs logiques,
dans lequel ledit deuxième ensemble de valeurs logiques est choisi selon que la dégradation du transistor de type p ou la dégradation du transistor de type n sera supprimée et de telle manière que
la valeur logique entrée à la première borne (A) d'entrée du premier circuit de LUT et la valeur logique délivrée en sortie de la borne de sortie du premier circuit de LUT sont la même de manière à mettre la même partie des premiers circuits (23) de porte dans un état désactivé dans le premier circuit (3) de LUT et le deuxième circuit (3) de LUT respectivement lorsque les circuits (3) de LUT fonctionnent dans le mode non oscillatoire.

9. Oscillateur en anneau dans un FPGA, comprenant :
un seul circuit de LUT comme un élément de retard,
un circuit (11, 13, 15, 17) de sélecteur configuré pour appliquer des valeurs logiques d'entrée au circuit (3) de LUT ;
le circuit de LUT incluant :
une partie (22) de mémoire ayant une pluralité de cellules (21) de mémoire individuelles stockant respectivement des valeurs logiques,
une borne de sortie,
une première borne (A) d'entrée connectée à la borne de sortie,
une pluralité de premiers circuits (23) de porte,
une deuxième borne (B) d'entrée différente de la première borne (A) d'entrée, et
une pluralité de deuxièmes circuits (25) de porte,
chacun des premiers circuits (23) de porte ayant :
au moins un transistor de type p et au moins un transistor de type n,
chacun des premiers circuits de porte étant mis dans un état activé ou un état désactivé en fonction de la valeur logique entrée à la première borne (A) d'entrée par le circuit (11, 13, 15, 17) de sélecteur, et
chacun des premiers circuits (23) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé, et entrant dans un état pour ne pas permettre le passage des valeurs logiques stockées dans les cellules (21) de mémoire individuelles jusqu'au côté borne de sortie dans l'état désactivé, chacun des deuxièmes circuits (25) de porte ayant :
au moins un transistor de type p et au moins un transistor de type n,
chacun des deuxièmes circuits (25) de porte étant mis dans un état activé ou un état désactivé en fonction de la valeur logique entrée à la deuxième borne (B) d'entrée par le circuit (11, 13, 15, 17) de sélecteur, et
chacun des deuxièmes circuits (25) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé, et entrant dans un état pour ne pas permettre le passage des valeurs logiques stockées dans les cellules (21) de mémoire individuelles jusqu'au côté borne de sortie dans l'état désactivé,
**caractérisé en ce que** ledit circuit (11, 13, 15, 17) de sélecteur est configuré pour faire fonctionner le circuit (3) de LUT dans un mode oscillatoire en appliquant un premier ensemble de valeurs logiques et pour faire fonctionner le circuit (3) de LUT dans un mode non oscillatoire en appliquant un deuxième ensemble de valeurs logiques,
dans lequel ledit deuxième ensemble de valeurs logiques est choisi selon que la dégradation du transistor de type p ou la dégradation du transistor de type p sera supprimée et de telle manière que, lors d'un fonctionnement dans le mode non oscillatoire, la partie (22) de mémoire et la borne de sortie sont connectées l'une à l'autre par l'intermédiaire d'une partie des deuxièmes circuits (25) de porte différente de la partie des deuxièmes circuits (25) de porte connectant la partie (22) de mémoire et la borne de sortie lors d'un fonctionnement dans le mode oscillatoire en entrant des valeurs logiques différentes à la deuxième borne d'entrée dans les différents modes de fonctionnement.

10. Capteur qui mesure une fréquence, une température, une tension ou le degré de variation en production et est équipé avec l'oscillateur en anneau selon l'une quelconque des revendications 1 à 9.

11. Procédé de commande d'un oscillateur en anneau dans un FPGA, dans lequel :
l'oscillateur en anneau a une pluralité de circuits de LUT comme éléments de retard connectés annulairement,
chacun des circuits de LUT incluant :
une partie (22) de mémoire ayant une pluralité de cellules (21) de mémoire individuelles stockant respectivement des valeurs logiques,
une borne de sortie connectée au circuit de LUT d'étage suivant,
une première borne (A) d'entrée connectée à une borne de sortie du circuit de LUT d'étage précédent, et
une pluralité de premiers circuits (23) de porte,
chacun des premiers circuits (23) de porte ayant :
au moins un transistor de type p et au moins un transistor de type n,
chacun des premiers circuits (23) de porte étant mis dans un état activé ou un état désactivé en fonction de la valeur logique entrée à la première borne (A) d'entrée, et
chacun des premiers circuits (23) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé, et entrant dans un état pour ne pas permettre le passage des valeurs logiques stockées dans les cellules (21) de mémoire individuelles jusqu'au côté borne de sortie dans l'état désactivé,
les circuits de LUT incluant des premier, deuxième et troisième circuits de LUT connectés dans l'ordre du côté entrée au côté sortie, et
le deuxième circuit de LUT et le troisième circuit de LUT ayant respectivement la même pluralité de premiers circuits (23) de porte,
**caractérisé en ce que** le procédé inclut le fonctionnement des circuits (3) de LUT dans un mode oscillatoire en appliquant un premier ensemble de valeurs logiques et le fonctionnement des circuits (3) de LUT dans un mode non oscillatoire en appliquant un deuxième ensemble de valeurs logiques,
dans lequel ledit deuxième ensemble de valeurs logiques est choisi selon que la dégradation du transistor de type p ou la dégradation du transistor de type n sera supprimée et de telle manière que
en l'absence d'oscillation, les mêmes premiers circuits (23) de porte sont mis dans un état désactivé dans le deuxième circuit de LUT et le troisième circuit de LUT en rendant identiques la valeur logique entrée à la première borne (A) d'entrée du deuxième circuit de LUT et la valeur logique délivrée en sortie de la borne de sortie du deuxième circuit de LUT.

12. Procédé de commande de l'oscillateur en anneau selon la revendication 11, dans lequel chacun des circuits de LUT incluant en outre une deuxième borne d'entrée différente de la première borne (A) d'entrée, et une pluralité de deuxièmes circuits (25) de porte,
dans lequel chacun des deuxièmes circuits (25) de porte incluant un transistor de type p et un transistor de type n et étant mis dans un état activé ou un état désactivé en fonction de la valeur logique entrée à la deuxième borne d'entrée,
dans lequel chacun des deuxièmes circuits (25) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé, et entrant dans un état pour ne pas permettre le passage des valeurs logiques stockées dans les cellules (21) de mémoire individuelles jusqu'au côté borne de sortie dans l'état désactivé,
dans lequel les deuxièmes circuits (25) de porte incluent respectivement des transistors de type p et des transistors de type n, et
le procédé de commande incluant une étape, en l'absence d'oscillation, de la partie (22) de mémoire et de la borne de sortie étant connectées l'une à l'autre par l'intermédiaire d'une partie des deuxièmes circuits (25) de porte différente de la partie des deuxièmes circuits (25) de porte apte à connecter la partie (22) de mémoire et la borne de sortie lors d'un fonctionnement dans le mode oscillatoire en entrant la valeur logique différente de la valeur logique entrée à la deuxième borne d'entrée du deuxième circuit de LUT lors d'un fonctionnement dans le mode oscillatoire à la deuxième borne d'entrée.

13. Procédé de commande de l'oscillateur en anneau selon la revendication 11 ou 12, dans lequel la cellule de mémoire individuelle connectée à la borne de sortie en l'absence d'oscillation stockant la valeur logique entrée à la première borne (A) d'entrée en l'absence d'oscillation dans chacun des circuits de LUT au moins autre que le circuit de LUT de premier étage.

14. Procédé de commande de l'oscillateur en anneau selon la revendication 11, dans lequel :
l'oscillateur en anneau a une deuxième borne (B) d'entrée différente de la première borne (A) d'entrée, et
une pluralité de deuxièmes circuits (25) de porte, chacun des deuxièmes circuits (25) de porte incluant au moins un transistor de type p et au moins un transistor de type n et étant mis dans un état activé ou un état désactivé en fonction de la valeur logique entrée à la deuxième borne (B) d'entrée,
chacun des deuxièmes circuits (25) de porte entrant dans un état pour permettre à la valeur logique dans une des cellules (21) de mémoire individuelles ou à la valeur logique inversée de la valeur logique dans une des cellules (21) de mémoire individuelles de passer jusqu'au côté borne de sortie dans l'état activé, et entrant dans un état pour ne pas permettre le passage des valeurs logiques stockées dans les cellules (21) de mémoire individuelles jusqu'au côté borne de sortie dans l'état désactivé,
les deuxièmes circuits (25) de porte ayant respectivement des transistors de type p et des transistors de type n, et
dans lequel, en l'absence d'oscillation, la partie (22) de mémoire et la borne de sortie étant connectées l'une à l'autre par l'intermédiaire d'une partie des deuxièmes circuits (25) de porte différente de la partie des deuxièmes circuits (25) de porte apte à connecter la partie (22) de mémoire et la borne de sortie lors d'un fonctionnement dans le mode oscillatoire en entrant la valeur logique différente de la valeur logique entrée à la deuxième borne d'entrée lors d'un fonctionnement dans le mode oscillatoire à la deuxième borne d'entrée dans au moins les deux circuits de LUT parmi les circuits de LUT.
